# EUROPEAN PATENT SPECIFICATION

(11) **EP 4 521 451 B1**
(45) Date of publication and mention of the grant of the patent: **04.02.2026**
(21) Application number: 24187698.6
(22) Date of filing: 10.07.2024
(51) Int. Cl.: H01L 21/768, H01L 23/522, H01L 23/532

(54) **SEMICONDUCTOR DEVICE**
HALBLEITERANORDNUNG
DISPOSITIF SEMI-CONDUCTEUR

(30) Priority: 08.09.2023 KR 20230119429
(43) Date of publication of application: 12.03.2025
(73) Proprietor: Samsung Electronics Co., Ltd., Suwon-si, Gyeonggi-do 16677 (KR)
(72) Inventor: PARK, Sanghyun, 16677 Suwon-si (KR)
(74) Representative: Marks & Clerk LLP

(56) References cited:
- US-A1- 2014 167 268
- US-A1- 2015 262 940
- US-A1- 2023 207 467

## Description

### TECHNICAL FIELD

The present inventive concept relates to a semiconductor device including an interconnection structure.

### DISCUSSION OF RELATED ART

As semiconductor devices become smaller and more highly integrated, widths of interconnections are also becoming smaller. However, as a width of an interconnection decreases, resistance may increase, and when a fine pattern of the interconnection is applied, a resistance value may increase rapidly, causing a problem of increased signal resistive-capacitive (RC) delay. For example, for the commonly used interconnection material such as copper (Cu), the resistance increases rapidly as the widths of interconnections decrease. Materials having a smaller amount of electron mean free path, such as ruthenium (Ru), iridium (Ir), or the like, may have a smaller change in resistance in comparison to copper (Cu) when the widths of interconnections decrease, but as the scaling of semiconductor devices continues and the widths of interconnections become about 10 nm or less, the resistance of materials having a smaller amount of electron mean free path also rapidly increases, causing a problem of increased RC delay. US 2014/0167268 Al proposes graphene and metal interconnects, and US 2015/0262940 Al discusses a semiconductor device including a graphene interconnect.

### SUMMARY

Embodiments of the present inventive concept provide a semiconductor device including an interconnection structure having reliability.

According to an embodiment of the present inventive concept, a semiconductor device is provided in accordance with claim 1. Further aspects and preferred embodiments are set out in claim 2 et seq. The semiconductor device may include an insulating structure, a first interconnection pattern having a first through-hole and disposed on an upper surface of the insulating structure, and a conductive via passing through the first through-hole of the first interconnection pattern and contacting the first interconnection pattern on an internal sidewall of the first through-hole, in which the first interconnection pattern includes a material having first resistivity in a first direction, parallel to the upper surface of the insulating structure, and second resistivity in a second direction, different from the first direction and not parallel to the upper surface of the insulating structure, and the first resistivity is lower than the second resistivity.

Also described is a semiconductor device includes an active region, an interlayer insulating layer disposed on the active region, a contact structure connected to the active region and passing through the interlayer insulating layer, an intermediate insulating structure having a first hole and disposed on the interlayer insulating layer, a first interconnection pattern having a second hole aligned with the first hole, disposed on the intermediate insulating structure and having anisotropic resistance characteristics, and a conductive via passing through the first hole and the second hole to be connected to the contact structure, and connected to the first interconnection pattern through an internal sidewall of the second hole.

Further described is a semiconductor device includes: an insulating structure including an intermediate insulating layer, a first etch stop layer on the intermediate insulating layer, and a second etch stop layer below the intermediate insulating layer, and including a lower through-hole exposing simultaneously the intermediate insulating layer, the first etch stop layer, and the second etch stop layer; a first interconnection pattern having a first through-hole aligned with the lower through-hole and disposed on the upper surface of the first etch stop layer; an upper etch stop layer having a second through-hole aligned with the first through-hole and disposed on the first interconnection pattern; and a conductive via including a material, different from that of the first interconnection pattern, simultaneously filling the first through-hole, the second through-hole, and the lower through-hole, and having an upper surface coplanar with the upper etch stop layer and a side surface directly contacting the first interconnection pattern through an internal sidewall of the first through-hole.

At least some of the above and other features of the invention are set out in the claims.

### BRIEF DESCRIPTION OF THE DRAWINGS

The above and other aspects, and features of the present inventive concept will be more clearly understood from the following detailed description, taken in conjunction with the accompanying drawings, in which:
FIGS. 1, 2A, and 2B are views schematically illustrating an example of a semiconductor device according to an embodiment of the present inventive concept;
FIG. 3 is a cross-sectional view schematically illustrating a modified example of a semiconductor device according to an embodiment of the present inventive concept;
FIG. 4 is a cross-sectional view schematically illustrating a modified example of a semiconductor device according to an embodiment of the present inventive concept;
FIG. 5 is a cross-sectional view schematically illustrating a modified example of a semiconductor device according to an embodiment of the present inventive concept;
FIG. 6 is a cross-sectional view schematically illustrating a modified example of a semiconductor device according to an embodiment of the present inventive concept;
FIG. 7 is a cross-sectional view schematically illustrating a modified example of a semiconductor device according to an embodiment of the present inventive concept;
FIG. 8 is a cross-sectional view schematically illustrating a modified example of a semiconductor device according to an embodiment of the present inventive concept;
FIG. 9 is a view schematically illustrating a modified example of a semiconductor device according to an embodiment of the present inventive concept;
FIG. 10 is a view schematically illustrating a modified example of a semiconductor device according to an embodiment of the present inventive concept;

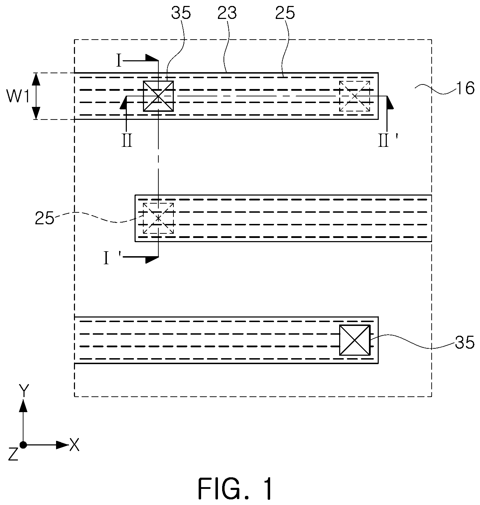

FIGS. 1 1A to 11M are cross-sectional views schematically illustrating an example of a method of manufacturing a semiconductor device according to an embodiment of the present inventive concept; and

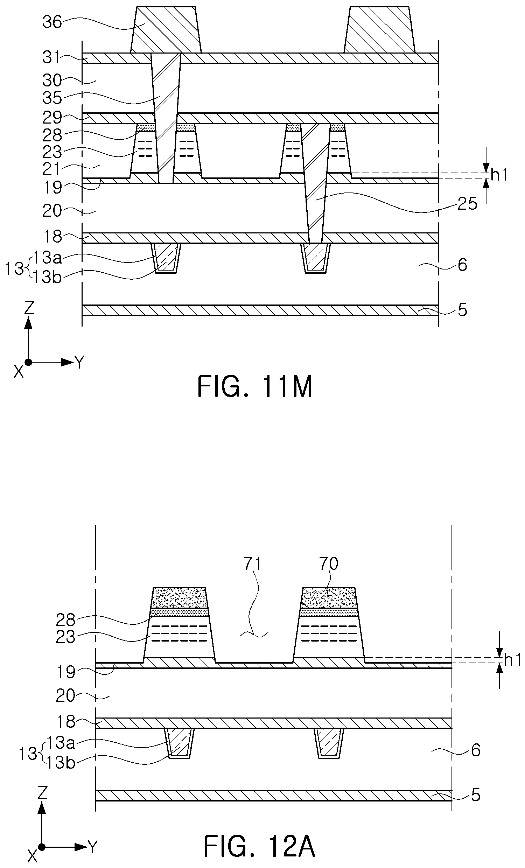

FIGS. 12A to 12I are cross-sectional views schematically illustrating an example of a method of manufacturing a semiconductor device according to an embodiment of the present inventive concept.

Since the drawings in FIGS. 1-12I are intended for illustrative purposes, the elements in the drawings are not necessarily drawn to scale. For example, some of the elements may be enlarged or exaggerated for clarity purpose.

### DETAILED DESCRIPTION OF THE EMBODIMENTS

Hereinafter, terms such as "upper", "intermediate", "lower" and the like may be replaced with other terms, such as "first", "second", "third" and the like, and may also be used to describe elements of the specification. Terms such as "first", "second", "third" and the like may be used to describe various components, but components are not limited by the terms. These terms are only used to distinguish one element or component from another element or component, and for example, "first component" may be termed a "second component".

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

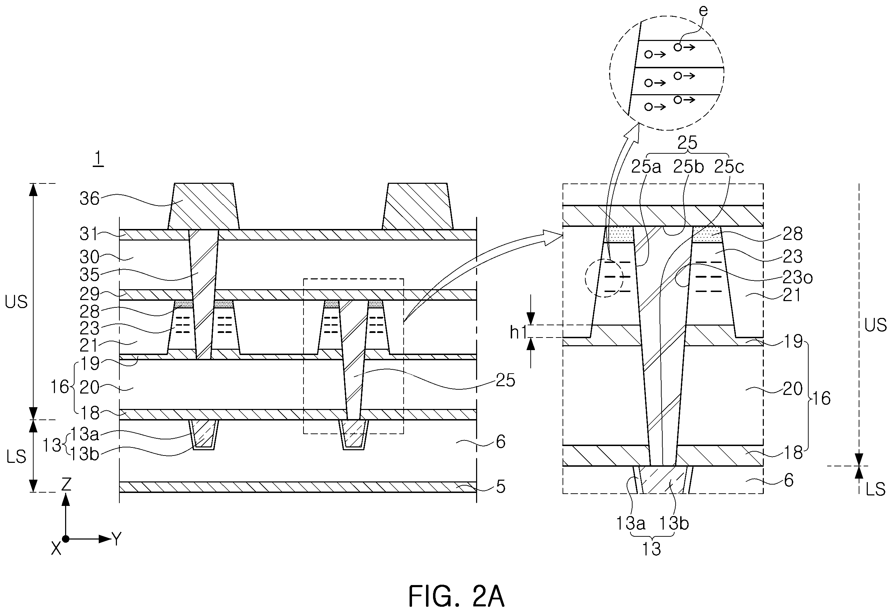

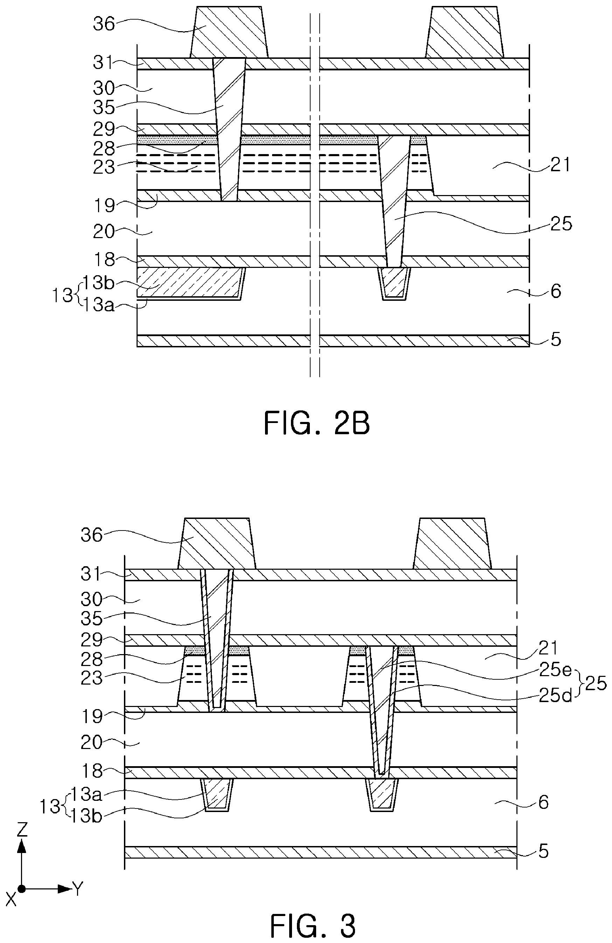

Referring to FIGS. 1, 2A, and 2B, an illustrative example of a semiconductor device 1 according to an embodiment of the present inventive concept will be described. FIGS. 1, 2A, and 2B are views schematically illustrating an illustrative example of a semiconductor device 1 according to an embodiment of the present inventive concept, FIG. 1 is a top view schematically illustrating an illustrative example of a semiconductor device 1 according to an embodiment of the present inventive concept, FIG. 2A is a cross-sectional view schematically illustrating a portion of FIG. 1, taken along line I-I', and FIG. 2B is a cross-sectional view schematically illustrating a portion of FIG. 1, taken along line II-II'.

Referring to FIGS. 1, 2A, and 2B, a semiconductor device 1 according to an embodiment of the present inventive concept may include a lower structure LS and an upper structure US on the lower structure LS.

The lower structure LS may include a base 5, a first lower insulating layer 6 on the base 5, and a lower interconnection structure 13 formed in the first lower insulating layer 6.

The first lower insulating layer 6 may include silicon oxide (SiO₂) or a low-κ dielectric.

The lower interconnection structure 13 may include an interconnection material layer 13b and a barrier material layer 13a covering side and bottom surfaces of the interconnection material layer 13b. The interconnection material layer 13b may include copper (Cu), and the barrier material layer 13a may include at least one of, for example, titanium (Ti), tantalum (Ta), titanium nitride (TiN), or tantalum nitride (TaN).

The upper structure US on the lower structure LS may include a first insulating structure 16 and a first interconnection structure (23 and 25) on the first insulating structure 16.

The first insulating structure 16 may include an intermediate insulating layer 20, a first etch stop layer 19 on the intermediate insulating layer 20, and a second etch stop layer 18 below the intermediate insulating layer 20.

In the upper structure US, the first etch stop layer 19 and the second etch stop layer 18 may be respectively disposed on and below the intermediate insulating layer 20, to function as an etch stop layer during etching a conductive via 25 and a first interconnection pattern 23. The first interconnection structure (23 and 25) may include two major components: the first interconnection pattern 23 that transfers current within the same device layer, and the conductive via 25 that transfers current between different device layers.

The intermediate insulating layer 20 may be, for example, silicon oxide (SiO₂), tetraethylorthosilicate (TEOS) oxide, carbon doped silicon oxide (SiOCH), or silicon oxycarbide (SiOC), but the present inventive concept is not limited thereto.

The first etch stop layer 19 and the second etch stop layer 18 may include the same material, and for example, may be an insulating material including at least one of, for example, aluminum nitride (AlN), silicon nitride (SiN), silicon boron nitride (SiBN), or silicon carbonitride (SiCN).

The first etch stop layer 19 and the second etch stop layer 18 may have the same thickness, but the present inventive concept is not limited thereto, and the intermediate insulating layer 20 may be formed thicker than the first and second etch stop layers 19 and 18.

The first interconnection structure (23 and 25) may be disposed on the first insulating structure 16, for example, on the first etch stop layer 19.

The first interconnection structure (23 and 25) may include first interconnection patterns 23 on the first etch stop layer 19.

The first interconnection patterns 23 may extend in one direction on a plane (X-Y plane), parallel to an upper surface of the first insulating structure 16, for example, an upper surface of the intermediate insulating layer 20.

The first interconnection patterns 23 may be cut in some regions to have an island shape, but the present inventive concept is not limited thereto. The first interconnection patterns 23 may have a predetermined thickness or less, and a predetermined width W1 or less on the X-Y plane, for example, a width of less than or equal to about 10 nm.

The first interconnection patterns 23 may include a material having anisotropic resistance characteristics. The material having the anisotropic resistance characteristic may be defined that a first resistivity value of the first interconnection patterns 23 in a direction (in-plane) (referred to as a first direction), parallel to the X-Y plane, is different from a second resistivity value of the first interconnection patterns 23 in a direction (out of plane) (referred to as a second direction), not parallel to the X-Y plane. For example, the second resistivity value may be tens to hundreds of times greater than the first resistivity value. Since the first interconnection pattern 23 may transfer current within the same device layer on the X-Y plane, when the first interconnection pattern 23 includes a material having anisotropic resistance characteristics to have electron mobility in the identical layered structure on the X-Y plane being very high, the first resistivity may be rapidly decrease. Therefore, signal RC delay may be reduced.

The first interconnection patterns 23 may be a multi-element material having anisotropic resistance characteristics, and may be a material in which multiple elements in a material form a hierarchical structure and are combined to have different characteristics between layers. For example, the first interconnection pattern 23 may include a conductive material including at least one of, for example, an intermetallic compound, an oxide, a carbide, a nitride, or a boride.

The first interconnection patterns 23 may be a carbide or a nitride, and may be a material having an MAX phase. For example, the first interconnection patterns 23 may be a material that satisfies a structural formula of Mₙ₊₁AXₙ, and may be any one of n=1, 2, 3, or 4. For example, the first interconnection patterns 23 may be a material having an M₂AX phase, an M₃AX₂ phase, or an M₄AX₃ phase.

In such a material of an MAX phase, M (metal-based) is an early transition metal, A is one of elements of groups 13 and 14, and X is carbon (C) and/or nitrogen (N).

In an embodiment of the present inventive concept, the material of the MAX phase, M may include, for example, scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), iron (Fe), cobalt (Co), and/or nickel (Ni), A may include, for example, aluminum (Al), gallium (Ga), indium (In), silicon (Si), germanium (Ge), tin (Sn), arsenic (As), cadmium (Cd), copper (Cu), zinc (Zn), nickel (Ni), platinum (Pt), palladium (Pd), silver (Ag), and/or gold (Au), and X may include, for example, carbon (C) and/or nitrogen (N).

**In** bonding of each layer, both covalent and metal bonding properties may exist between M-X to have very strong bonds, relatively weak bonds may exist between M-A, and a very large amount of density of states may exist by the orbital of M at the Fermi level. Therefore, electrons may easily move around M, and thus anisotropic low resistance characteristics may be expressed.

**In** an embodiment of the present inventive concept, a material having an M₂AX phase may be, for example, titanium aluminum carbide (Ti₂AlC), titanium aluminum nitride (Ti₂AlN), titanium silicon carbide (Ti₂SiC), titanium gallium nitride (Ti₂GaN), titanium germanium carbide (Ti₂GeC), titanium germanium nitride (Ti₂GeN), titanium indium carbide (Ti₂InC), titanium indium nitride (Ti₂InN), vanadium aluminum carbide (V₂AlC), vanadium aluminum nitride (V₂AlN), vanadium silicon carbide (V₂SiC), vanadium silicon nitride (V₂SiN), vanadium gallium carbide (V₂GaC), vanadium gallium nitride (V₂GaN), vanadium germanium carbide (V₂GeC), vanadium arsenic nitride (V₂AsN), vanadium cadmium carbide (V₂CdC), vanadium cadmium nitride (V₂CdN), vanadium indium carbide (V₂InC), vanadium tin nitride (V₂SnN), chromium aluminum carbide (Cr₂AlC), chromium silicon carbide (Cr₂SiC), chromium silicon nitride (Cr₂SiN), chromium gallium carbide (Cr₂GaC), chromium germanium nitride (Cr₂GeN), chromium arsenic carbide (Cr₂AsC), chromium arsenic nitride (Cr₂AsN), chromium indium nitride (Cr₂InN), chromium tin nitride (Cr₂SnN), tantalum aluminum carbide (Ta₂AlC), tantalum silicon carbide (Ta₂SiC), tantalum gallium carbide (Ta₂GaC), or tantalum indium carbide (Ta₂InC). Alternatively, a material having an M₃AX₂ phase may be, for example, titanium aluminum carbide (Ti₃AlC₂), titanium silicon carbide (Ti₃SiC₂), titanium gallium nitride (Ti₃GaN₂), titanium germanium carbide (Ti₃GeC₂), titanium germanium nitride (Ti₃GeN₂), titanium indium carbide (Ti₃InC₂), titanium indium nitride (Ti₃InN₂), titanium tin carbide (Ti₃SnC₂), vanadium aluminum carbide (V₃AlC₂), vanadium aluminum nitride (V₃AlN₂), vanadium silicon carbide (V₃SiC₂), vanadium silicon nitride (V₃SiN₂), vanadium gallium carbide (V₃GaC₂), vanadium gallium nitride (V₃GaN₂), vanadium germanium carbide (V₃GeC₂), vanadium germanium nitride (V₃GeN₂), vanadium arsenic carbide (V₃AsC₂), vanadium arsenic nitride (V₃AsN₂), vanadium cadmium carbide (V₃CdC₂), vanadium cadmium nitride (V₃CdN₂), vanadium indium carbide (V₃InC₂), vanadium indium nitride (V₃InN₂), vanadium tin carbide (V₃SnC₂), vanadium tin nitride (V₃SnN₂), tantalum aluminum carbide (Ta₃AlC₂), chromium aluminum carbide (Cr₃AlC₂), chromium gallium carbide (Cr₃GaC₂), chromium gallium nitride (Cr₃GaN₂), chromium germanium carbide (Cr₃GeC₂), chromium germanium nitride (Cr₃GeN₂), chromium arsenic nitride (Cr₃AsN₂), chromium cadmium nitride (Cr₃CdN₂), chromium indium nitride (Cr₃InN₂), chromium tin nitride (Cr₃SnN₂), tantalum aluminum nitride (Ta₃AlN₂), or tantalum silicon carbide (Ta₃SiC₂). Alternatively, a material having an M₄AX₃ phase may be, for example, titanium aluminum carbide (Ti₄AlC₃), titanium silicon carbide (Ti₄SiC₃), titanium gallium carbide (Ti₄GaC₃), titanium germanium nitride (Ti₄GeN₃), titanium indium carbide (Ti₄InC₃), titanium indium nitride (Ti₄InN₃), vanadium aluminum carbide (V₄AlC₃), vanadium aluminum nitride (V₄AlN₃), vanadium silicon nitride (V₄SiN₃), vanadium gallium carbide (V₄GaC₃), vanadium gallium nitride (V₄GaN₃), vanadium germanium carbide (V₄GeC₃), vanadium arsenic nitride (V₄AsN₃), vanadium cadmium carbide (V₄CdC₃), vanadium cadmium nitride (V₄CdN₃), vanadium indium carbide (V₄InC₃), vanadium indium nitride (V₄InN₃), vanadium tin carbide (V₄SnC₃), vanadium tin nitride (V₄SnN₃), chromium aluminum carbide (Cr₄AlC₃), chromium silicon nitride (Cr₄SiN₃), chromium germanium nitride (Cr₄GeN₃), tantalum aluminum carbide (Ta₄AlC₃), or tantalum silicon carbide (Ta₄SiC₃), but the present inventive concept is not limited thereto.

The first interconnection patterns 23 may be an oxide including a delafossite-based material. For example, the first interconnection patterns 23 may be delafossite, which has a structural formula of ABO₂ as an oxide. The delafossite may be a hierarchical structure formed by layers of linearly coordinated A+ stacked between edge-shared octahedral layers (BO₂)-. A material of A may be one of, for example, platinum (Pt), palladium (Pd), silver (Ag), or copper (Cu), and a material of B may be a transition metal such as, for example, chromium (Cr), cobalt (Co), iron (Fe), rhodium (Rh), aluminum (Al), gallium (Ga), scandium (Sc), indium (In), thallium (Tl), or the like.

In an embodiment of the present inventive concept, the first interconnection patterns 23 may be one of, for example, platinum cobalt oxide (PtCoO₂), palladium cobalt oxide (PdCoO₂), strontium molybdenum oxide (SrMoO₃), strontium ruthenium oxide (Sr₂RuO₄), platinum chromium oxide (PtCrO₂), palladium rhodium oxide (PdRhO₂), palladium chromium oxide (PdCrO₂), copper iron oxide (CuFeO₂), sodium cobalt oxide (NaCoO₂), lithium cobalt oxide (LiCoO₂), silver iron oxide (AgFeO₂), silver chromium oxide (AgCrO₂), copper chromium oxide (CuCrO₂), or silver nickel oxide (AgNiO₂), but the present inventive concept is not limited thereto.

The first interconnection patterns 23 may be intermetallic compounds, and may include a topological semimetal material or the like.

The topological semimetal material may have an electronic gapless phase with topological band crossings around a Fermi level. The topological semimetal material may have a surface state induced by this topology, and a topological Dirac semimetal or a topological Weyl semimetal may have a three-dimensional structure of graphene, to have very high electrical conductivity to each two-dimensional layer. The topological semimetal material may have a structural formula such as, for example, T₃X, T₃X₂, TX, or the like, where T is any one of, for example, sodium (Na), cadmium (Cd), platinum (Pt), nickel (Ni), lanthanum (La), molybdenum (Mo), tungsten (W), aluminum (Al), iron (Fe), manganese (Mn), or cobalt (Co), and X is any one of, for example, germanium (Ge), tin (Sn), or tellurium (Te), but the present inventive concept is not limited thereto.

In an embodiment of the present inventive concept, the first interconnection patterns 23 may be any one of, for example, sodium bismuthide (Na₃Bi), cadmium arsenide (Cd₃As₂), platinum telluride (PtTe₂), nickel telluride (NiTe₂), lanthanum strontium copper oxide (La_{1.77}Sr_{0.23}CuO₄), thallium molybdenum selenide (Tl(MoSe)₃), cerium antimony telluride (CeSbTe), tantalum arsenide (TaAs), tantalum selenium iodide ((TaSe₄)₂I), molybdenum tungsten telluride (Mo₁₋ₓWₓTe₂), lanthanum aluminum germanide (LaAlGe), tantalum iridium telluride (TaIrTe₄), molybdenum phosphide (MoP₂), ytterbium manganese bismuthide (YbMnBi₂), manganese germanide (Mn₃Ge), gadolinium platinum bismuthide (GdPtBi), cobalt tin sulfide (Co₃Sn₂S₂), europium cadmium arsenide (EuCd₂As₂), molybdenum phosphide (MoP), tungsten carbide (WC), cobalt silicide (CoSi), rhodium silicide (RhSi), Aluminum platinum (AlPt), palladium gallide (PdGa), palladium bismuth selenide (PdBiSe), calcium silver arsenide (CaAgAs), magnesium boride (MgB₂), platinum tin (PtSn₄), strontium arsenide (SrAs₃), lead tantalum selenide (PbTaSe₂), zirconium silicon sulfide (ZrSiS), indium bismuthide (InBi), iridium oxide (IrO₂), ruthenium oxide (RuO₂), titanium boride (TiB₂), magnesium bismuthide (Mg₃Bi₂), cobalt manganese gallide (Co₂MnGa), or tantalum silicon telluride (Ta₃SiTe₆), but the present inventive concept is not limited thereto.

The first interconnection patterns 23 may be a material having a hierarchical structure, among boride materials, and may be any one of, for example, osmium tungsten boride (B₄OsW), manganese boride (Mn₂B), rhenium boride (ReB₂), hafnium cobalt boride (HfCo₃B₂), zirconium cobalt boride (ZrCo₃B₂), yttrium cobalt boride (YCo₃B₂), niobium iron boride (NbFeB), scandium cobalt boride (ScCo₃B₂), or tantalum iron boride (TaFeB), but the present inventive concept is not limited thereto.

In an embodiment of the present inventive concept, the first interconnection patterns 23 may be primarily one of a topological semimetal or a boride, and may include a material of, for example, osmium ruthenium (OsRu), niobium platinum (NbPt), osmium tungsten boride (B₄OsW), hafnium nickel antimonide (Hf₆NiSb₂), zirconium aluminum cobalt (Zr₆Al₂Co), zirconium aluminum nickel (Zr₆Al₂Ni), manganese boride (Mn₂B), scandium germanium rhodium (ScGeRh), rhenium boride (ReB₂), cobalt tin (CoSn), hafnium iron germanide (HfFeGe), titanium aluminum platinum (TiAlPt), hafnium aluminum platinum (Hf₆Al₂Pt), hafnium cobalt boride (HfCo₃B₂), niobium gold (NbAu₂), copper telluride (CuTe), zirconium cobalt boride (ZrCo₃B₂), hafnium germanium ruthenium (HfGeRu), yttrium cobalt boride (YCo₃B₂), niobium iron boride (NbFeB), scandium phosphorus ruthenium (ScPRu), titanium gallium palladium (TiGaPd), hafnium germanium osmium (HfGeOs), titanium gallium platinum (TiGaPt), hafnium silicon ruthenium (HfSiRu), scandium cobalt boride (ScCo₃B₂), hafnium silicon osmium (HfSiOs), zirconium germanium osmium (ZrGeOs), zirconium silicon ruthenium (ZrSiRu), or tantalum iron boride (TaFeB).

A material forming the first interconnection patterns 23 may form an identical layered structure in a direction (in-plane), parallel to the X-Y plane, which may be an upper surface of a lower insulating structure, for example, a deposition surface of the first interconnection patterns 23, and may have a hierarchical structure in the Z-direction, perpendicular to the X-Y plane.

Electron mobility in the identical layered structure may be very high to rapidly decrease resistivity, and electron mobility between layers may be very low to rapidly increase resistivity in a direction (out of plane), different from the X-Y plane.

A material having a hierarchical structure may be applied to the first interconnection patterns 23, to prevent an increase in resistance in the fine pattern by utilizing a significantly low resistivity in a direction (in-plane), parallel to the X-Y plane.

The first interconnection patterns 23 may include a first through-hole 23o therein.

The first through-hole 23o may pass through from an upper surface to a lower surface of the first interconnection patterns 23, and a diameter of the first through-hole 23o may become smaller downward in the Z-direction.

The first interconnection structure (23 and 25) may further include a conductive via 25 for connecting the first interconnection patterns 23 and the lower interconnection structure 13 of the lower structure LS.

The conductive via 25 may pass through the first through-hole 23o, and may be in direct contact with a side surface of the first interconnection patterns 23 on an internal sidewall of the first through-hole 23o.

The conductive via 25 may include a material, different from that of the first interconnection patterns 23, and may be a material having isotropic resistance characteristics. For example, the conductive via 25 may include, for example, ruthenium (Ru), molybdenum (Mo), cobalt (Co), copper (Cu), aluminum (Al), or tungsten (W) as a material having resistivity in an approximate range regardless of a stacking direction. Since, the conductive via 25 includes a material having the isotropic resistance characteristic, the resistivity value of the conductive via 25 in a direction (in-plane) (referred to as the first direction), parallel to the X-Y plane, is the same as the resistivity value of the conductive via 25 in a direction (out of plane) (referred to as the second direction), not parallel to the X-Y plane. Accordingly, the conductive via 25 may be able to transfer current between different layers with low resistance, and thus, signal RC delay may be reduced.

The conductive via 25 and the first interconnection patterns 23 may have a pad surface directly contacting the internal sidewall of the first through-hole 23o, to contact the conductive via 25 in a first direction in which resistivity of the first interconnection patterns 23 is low, to significantly decrease contact resistance. Therefore, signal RC delay may be reduced. In other words, since the interconnection material of the first interconnection patterns 23 has anisotropic resistance characteristics with low resistivity in-plane (e.g., X-Y plane) and sharply high resistivity out of plane, a contact surface with the conductive via 25 is formed in-plane of the first interconnection patterns 23 to have low contact resistance. For example, the first interconnection patterns 23 may contact the conductive via 25 in a direction (in-plane) (referred to as the first direction), parallel to the X-Y plane to have low contact resistance.

Depending on a shape of the first through-hole 23o, the conductive via 25 may also have a width decreasing in a downward direction. The conductive via 25 may include an upper surface 25b, a lower surface 25c, and a side surface 25a connecting the upper surface 25b and the lower surface 25c.

The side surface 25a may be inclined at a predetermined angle, which may be a constant angle, in the first direction due to a difference in areas between the upper surface 25b and the lower surface 25c, and the upper surface 25b may have a level, equal to or higher than the upper surface of the first interconnection patterns 23, and the lower surface 25c may have a level, lower than the lower surface of the first interconnection patterns 23.

An upper etch stop layer 28 may be further included on the first interconnection patterns 23.

The upper etch stop layer 28 may function as a polishing stop layer, when the conductive via 25 is formed by chemical mechanical polishing (CMP).

The upper etch stop layer 28 may include a third through-hole through which the conductive via 25 passes, and the third through-hole may be aligned with the first through-hole 23o. An upper surface of the upper etch stop layer 28 may be coplanar with the upper surface 25b of the conductive via 25.

The conductive via 25 may successively pass through the upper etch stop layer 28, the first interconnection pattern 23, and the first etch stop layer 19, and may be in direct contact with the internal sidewall of the first through-hole 23o of the first interconnection pattern 23 and the side surface 25a of the conductive via 25, to form a pad surface. In this case, the pad surface is a contact surface between the first interconnection pattern 23 and the conductive via 25, and the first interconnection pattern 23 and the conductive via 25 may contact each other in a direction (in-plane) (referred to as the first direction), parallel to the X-Y plane to have low contact resistance.

A first interconnection insulating layer 21 may be disposed in a space between the first interconnection patterns 23.

The first interconnection insulating layer 21 may be embedded such that the first interconnection patterns 23 may be spaced apart from each other, and may have a top surface being coplanar with that of the upper etch stop layer 28. The first interconnection insulating layer 21 may be formed of a material the same as that of the intermediate insulating layer 20, or may be formed of an insulating material such as, for example, silicon oxide (SiO₂) or the like.

A lower surface of the first interconnection insulating layer 21 may be on a level lower than that of the lower surface of the first interconnection pattern 23. When the first etch stop layer 19 includes a first region located below the first interconnection patterns 23, and a different region, for example, a second region disposed below the first interconnection insulating layer 21, a portion of the second region may be removed to have a step difference of a predetermined depth h1. For example, the first region may be located below the first interconnection pattern 23 and the second region may exclude the first region. Therefore, a thickness of the first etch stop layer 19 may vary depending on a region such that an upper surface of the first region has a level, higher than a level of an upper surface of the second region, and a lower surface of the first region has a level, equal to a level of a lower surface of the second region.

Due to the step difference of the first etch stop layer 19, the lower surface of the first interconnection insulating layer 21 may be formed lower than the lower surface of the first interconnection pattern 23, resulting in insulation such that residual metal does not exist between the first interconnection patterns 23. In this case, during the process of removing a portion of an interconnection layer to form the first interconnection patterns 23, the etching process may be performed to remove the portion of the interconnection layer primarily to an upper surface of the first etch stop layer 19, and secondarily, additional etching may be performed to overetch the first etch stop layer 19 to have a step difference of the depth h1.

A second insulating structure (29, 30, and 31) may be further included on the first interconnection patterns 23 and the first interconnection insulating layer 21.

Like the first insulating structure 16, the second insulating structure (29, 30, and 31) may have a stacked structure of an intermediate insulating layer 30, and a first etch stop layer 31 and a second etch stop layer 29, respectively, on and below the intermediate insulating layer 30.

Upper interconnection structures 36 may be further included on the second insulating structure (29, 30, and 31).

A thickness and a material of each layer of the second insulating structure (29, 30, and 31) may be the same as those of the first insulating structure 16. For example, the first etch stop layer 31 and the second etch stop layer 29 may have the same thickness, but the present inventive concept is not limited thereto, and the intermediate insulating layer 30 may be formed thicker than the first and second etch stop layers 31 and 29.

When interconnection structures connected by the conductive vias 25 are lower interconnection structures 13 disposed below the first interconnection patterns 23, the conductive vias 25 may pass through the first interconnection patterns 23, and may extend in a downward direction.

For the conductive via 25 to pass through, a through-hole aligned with the first through-hole 23o and exposing the upper surface of the lower interconnection structure 13 may be disposed in the first insulating structure 16. For example, the first etch stop layer 19, the intermediate insulating layer 20 and the second etch stop layer 18 may include the through-hole aligned with the first through-hole 23o and through which the conductive via 25 passes.

The conductive via 25 may extend integrally from the upper etch stop layer 28 to the upper surface of the lower interconnection structure 13, and a pad surface with the first interconnection pattern 23 may be disposed in first through-hole 23o passing through the first interconnection patterns 23 to form a wedge-shaped conductive structure (23 and 25). The conductive via 26 having the wedge-shaped structure may provide a low contact resistance with the first interconnection pattern 23 at the pad surface disposed in the first through-hole 23o passing through the first interconnection pattern 23.

When an interconnection structure connected to the conductive via 25 is the upper interconnection structure 36 disposed above the first interconnection patterns 23, an upper conductive via 35 passing through the first interconnection patterns 23 to connect the upper interconnection structure 36 may be further included.

An upper through-hole aligned with the first through-hole 23o of the first interconnection patterns 23 may be disposed in the second insulating structure (29, 30, and 31) such that the upper conductive via 35 extends in an upward direction.

The upper conductive via 35 may integrally extend from the first etch stop layer 19 to the first etch stop layer 31 of the second insulating structure (29, 30, and 31), and a pad surface with the first interconnection pattern 23 may be disposed on the internal sidewall of the first through-hole 23o of the first interconnection pattern 23 to form a wedge-shaped conductive structure.

When the upper conductive via 35 extends in an upward direction to be connected to the upper interconnection structure 36, a lower surface of the upper conductive via 35 may be coplanar with a lower surface of the first etch stop layer 19, and when the conductive via 25 extends in a downward direction to be connected to the lower interconnection structure 13, an upper surface of the conductive via 25 may be coplanar with an upper surface of the upper etch stop layer 28.

Hereinafter, various modified examples of components of the above-described embodiment will be described. Various modified examples to the components of the above-described embodiment described below will be explained with a focus on components to be modified or replaced. In addition, the components that may be modified or replaced below may be described with reference to the drawings mentioned below, but the components that may be modified or replaced may be combined with each other or with the components described above to configure a semiconductor device 1 according to an embodiment of the present inventive concept.

FIG. 3 may be a cross-sectional view schematically illustrating a portion taken along line I-I' of FIG. 1, to illustrate a modified example of the conductive via illustrated in FIGS. 2A and 2B.

In a modified example, referring to FIG. 3, a conductive via 25, as illustrated in FIGS. 2A and 2B, may include a barrier material layer 25d and a via material layer 25e. For example, the barrier material layer 25d may be a conductive barrier layer formed on a side surface of the via material layer 25e. For example, the conductive barrier layer is disposed between the internal sidewall of the first through-hole 23o and the via material layer 25e, to directly contact the first interconnection pattern 23 and the via material layer 25e.

The via material layer 25e may be formed by filling a via hole in which first to third through-holes and a through-hole of a first insulating structure 16 are integrally connected, and may be a metal material such as, for example, ruthenium (Ru), molybdenum (Mo), cobalt (Co), copper (Cu), tungsten (W), aluminum (Al), or the like. The barrier material layer 25d may be further entirely included on a side surface 25a and a lower surface 25c of the via material layer 25e. The barrier material layer 25d may be formed to protect insulating layers 18, 19, and 20 from diffusion of some metals, and may include at least one of, for example, titanium (Ti), tantalum (Ta), titanium nitride (TiN), or tantalum nitride (TaN). In this case, the pad surface is a contact surface between the first interconnection pattern 23 and the barrier material layer 25d, and the first interconnection pattern 23 and the barrier material layer 25d may contact each other in a direction (in-plane) (referred to as the first direction), parallel to the X-Y plane to have low contact resistance.

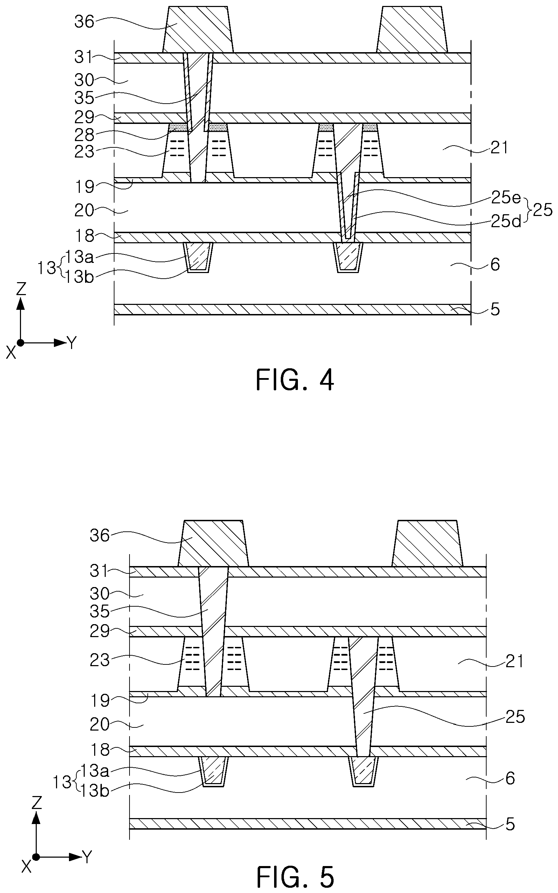

FIG. 4 may be a cross-sectional view schematically illustrating a portion taken along line I-I' of FIG. 1, to illustrate a modified example of the conductive via illustrated in FIGS. 2A and 2B.

In a modified example, referring to FIG. 4, a conductive via 25, as illustrated in FIGS. 2A and 2B, may include a barrier material layer 25d and a via material layer 25e.

The via material layer 25e may be formed by filling a via hole in which first to third through-holes and a through-hole of a first insulating structure 16 are integrally connected, and may be a metal material such as, for example, ruthenium (Ru), molybdenum (Mo), cobalt (Co), copper (Cu), tungsten (W), aluminum (Al), or the like. The barrier material layer 25d may be further entirely included on a portion of a side surface 25a and a lower surface 25c of the via material layer 25e. The barrier material layer 25d may not be disposed on a side surface of a first through-hole 23o, but may be selectively disposed only in a region facing an insulating layer. For example, the barrier material layer 25d may be formed on the side surface of the via material layer 25e from a first etch stop layer 19 to a second etch stop layer 18, to protect the insulating layer from diffusion of some metals, and may include at least one of, for example, titanium (Ti), tantalum (Ta), titanium nitride (TiN), or tantalum nitride (TaN). Therefore, the barrier material layer 25d may prevent an increase in contact resistance on a contact surface between a first interconnection pattern 23 and a conductive via 25. In this case, the pad surface is a contact surface between the first interconnection pattern 23 and the via material layer 25e, and the first interconnection pattern 23 and the via material layer 25e may contact each other in a direction (in-plane) (referred to as the first direction), parallel to the X-Y plane to have low contact resistance.

FIG. 5 may be a cross-sectional view schematically illustrating a portion taken along line I-I' of FIG. 1, to illustrate a modified example of the first interconnection pattern 23 illustrated in FIGS. 2A and 2B.

In a modified example, referring to FIG. 5, in a state in which an upper etch stop layer 28 on a first interconnection pattern 23, as illustrated in FIGS. 2A and 2B, is removed, an upper surface of the first interconnection pattern 23 may be coplanar with an upper surface of a conductive via 25. In this case, during a planarization process to etch an insulating layer until the upper etch stop layer 28 is exposed, when the planarization is further performed until an upper surface of the first interconnection pattern 23 is exposed, the upper etch stop layer 28 may be completely removed.

In this manner, when the upper surface of the first interconnection pattern 23 and the upper surface of the conductive via 25 are coplanar, a thickness of a semiconductor device 1 may be reduced, miniaturization thereof may be achieved, and a length of the conductive via 25 may be minimized.

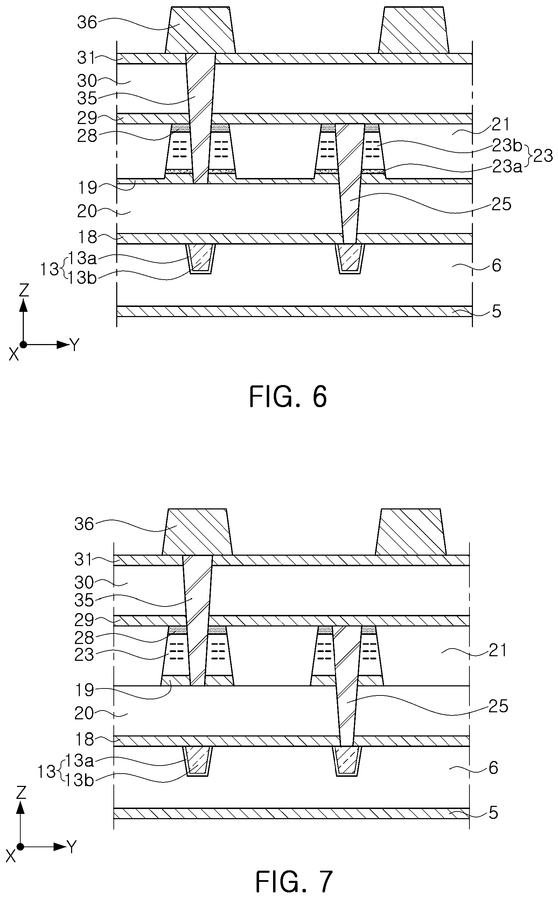

FIG. 6 may be a cross-sectional view schematically illustrating a portion taken along line I-I' of FIG. 1, to illustrate a modified example of the first interconnection pattern 23 illustrated in FIGS. 2A and 2B.

In a modified example, referring to FIG. 6, first interconnection patterns 23, as illustrated in FIGS. 2A and 2B, may further include an interconnection seed layer 23a on a lower surface thereof.

The first interconnection patterns 23 may include a stacked structure in which an interconnection seed layer 23a and a first interconnection material layer 23b on the interconnection seed layer 23a are arranged.

As described above, the first interconnection material layer 23b may include a material forming a hierarchical structure to have anisotropic resistance characteristics.

The first interconnection patterns 23 may further include an interconnection seed layer 23a for controlling growth direction of crystals of the first interconnection material layer 23b during deposition in a process for forming the hierarchical structure.

The interconnection seed layer 23a may be implemented with a crystalline material, and may be a polycrystalline material layer such as, for example, polysilicon (p-Si) or the like.

In this manner, after forming the interconnection seed layer 23a, deposition may be performed to reduce the number of times electrons passing through a crystal plane when moving in-plane, and thus, further lowering resistivity in-plane may be achieved.

FIG. 7 may be a cross-sectional view schematically illustrating a portion taken along line **I-I'** of FIG. 1, to illustrate a modified example of the first etch stop layer 19 illustrated in FIGS. 2A and 2B.

In a modified example, referring to FIG. 7, a first etch stop layer 19 may be selectively disposed only below first interconnection patterns 23.

The first etch stop layer 19 may not be disposed in a spaced region between the first interconnection patterns 23, such that an upper first interconnection insulating layer 21 and a lower intermediate insulating layer 20 may be in direct contact with each other. In this case, during the process of removing a portion of an interconnection layer to form the first interconnection patterns 23, the etching process may be performed to remove the portion of the interconnection layer primarily to an upper surface of the first etch stop layer 19, and secondarily, additional etching may be performed to completely remove the first etch stop layer 19 to expose the lower intermediate insulating layer 20.

In this manner, when patterning the first interconnection patterns 23 such that the first etch stop layer 19 is completely removed, a remaining metal of the first interconnection patterns 23 may reduce leakage current occurring and remaining above the first etch stop layer 19.

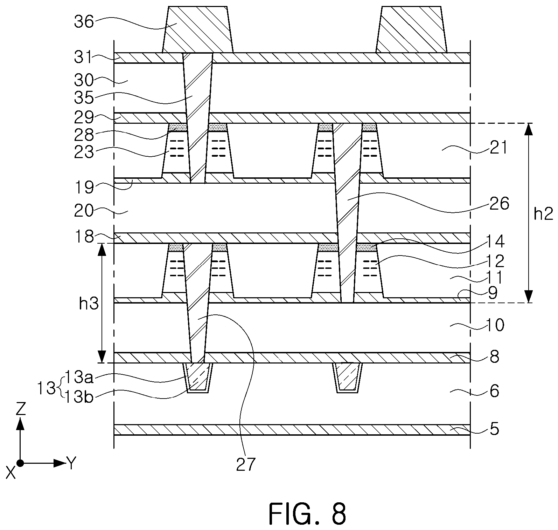

FIG. 8 may be a cross-sectional view schematically illustrating a portion taken along line I-I' of FIG. 1, to illustrate a modified example of the conductive via 25 illustrated in FIGS. 2A and 2B.

In a modified example, referring to FIG. 8, a semiconductor device 1 may further include an intermediate insulating structure (8, 9, and 10) and second interconnection patterns 12 below first interconnection patterns 23.

The intermediate insulating structure (8, 9, and 10) may be disposed below a first insulating structure 16 (18, 19, 20), and the second interconnection patterns 12 between the first insulating structure 16 (18, 19, 20) and the intermediate insulating structure (8, 9, and 10) and a second interconnection insulating layer 11 separating the second interconnection patterns 12 may be further included.

A layer structure, a thickness, and a material of each layer of the intermediate insulating structure (8, 9, and 10) may be the same as the first insulating structure 16 described above. Like the first insulating structure 16, the intermediate insulating structure (8, 9, and 10) may have a stacked structure of an intermediate insulating layer 10, and a first etch stop layer 9 and a second etch stop layer 8, respectively, on and below the intermediate insulating layer 10. For example, the first etch stop layer 9 and the second etch stop layer 8 may have the same thickness, but the present inventive concept is not limited thereto, and the intermediate insulating layer 10 may be formed thicker than the first and second etch stop layers 9 and 8.

A material, a layer structure, and a thickness of each layer of the second interconnection patterns 12 and a material, a layer structure, and a thickness of each layer of the second interconnection insulating layer 11 may be the same as those of the first interconnection patterns 23 and those of a first interconnection insulating layer 21, respectively.

The second interconnection patterns 12 may also include a material having anisotropic resistance characteristics, and a conductive vias (26 and 27) may each form a pad surface on an internal sidewall of a through-hole in the second interconnection patterns 12.

A conductive via 26 may be a structure for electrically connecting the first interconnection patterns 23 and the second interconnection patterns 12, may include a material, different from that of the first interconnection patterns 23 and the second interconnection patterns 12, and may pass through integrally from an upper surface of the second interconnection patterns 12 to a lower surface of the first interconnection patterns 23.

The conductive via 26 between two layers of interconnection patterns 23 and 12 may not be in contact with the interconnection patterns 23 and 12 in a vertical direction, and an internal sidewall of a through-hole of each of the first interconnection patterns 23 and an internal sidewall of a through-hole of each of the second interconnection patterns 12 may be in contact with the conductive via 26 in a lateral direction.

When multilayer interconnection patterns are implemented as fine patterns having a width of about 10 nm or less, to prevent a rapid increase in resistance of each interconnection pattern, a material having anisotropic resistance characteristics may be applied to each interconnection pattern. **In** this case, the conductive via 26 may have a wedge-shaped structure simultaneously passing through a multilayer interconnection pattern to contact the conductive via 26 in-plane, which has low resistance due to anisotropic resistance characteristics. **In** this case, the pad surfaces are contact surfaces between the first interconnection pattern 23 and the conductive via 26, and between the second interconnection pattern 12 and the conductive via 26. The first interconnection pattern 23 and the second interconnection pattern 12 may contact the conductive via 26 in a direction (in-plane) (referred to as the first direction), parallel to the X-Y plane to have low contact resistance.

When simultaneously passing through the first interconnection patterns 23 and the second interconnection patterns 12, in FIG. 8, a length h2 of the conductive via 26 may be longer than a length h3 of a conductive via (27 and 35) passing through a single-layered second interconnection patterns 12 or a single-layered first interconnection patterns 23.

**In** FIG. 8, although the second interconnection patterns 12 are illustrated as a lower interconnection structure disposed below the first interconnection patterns 23, based on the first interconnection patterns 23, it can also be understood that the second interconnection patterns 12 may be formed on (above) the first interconnection patterns 23 based on the first interconnection patterns 23. For example, the second interconnection pattern 12 may be an upper interconnection structure or a lower interconnection structure including the second interconnection pattern 12 which includes a material identical to that of the first interconnection pattern 23. The second interconnection pattern 12 may include a through-hole aligned with the first through-hole 23o. The conductive via 26 may simultaneously pass through the first through-hole 23o and the through-hole of the second interconnection pattern 12, and may connect the first interconnection pattern 23 and the second interconnection pattern 12. The second interconnection pattern 12 may include an upper etch stop layer 14.

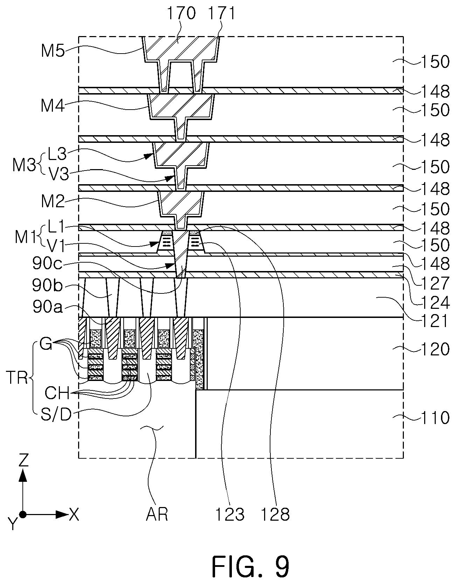

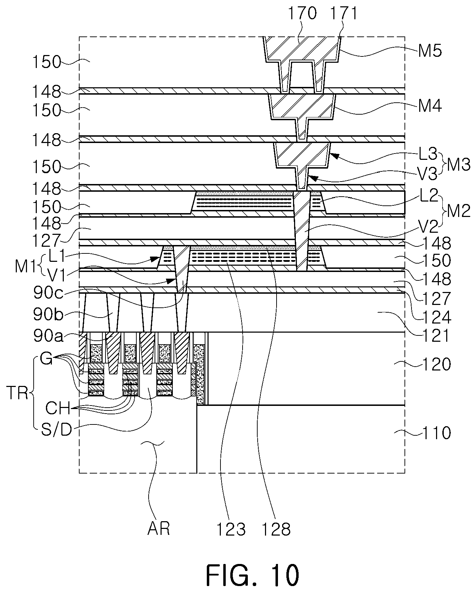

Next, with reference to FIGS. 9 and 10, an illustrative example of a semiconductor device 1 including any one of the embodiments described with reference to FIGS. 1 to 8 will be described. FIG. 9 may be a cross-sectional view schematically illustrating an illustrative example of a semiconductor device 1 according to an embodiment of the present inventive concept.

The semiconductor device 1 may include a circuit element TR including a transistor on a semiconductor substrate, and contact plugs 90a, 90b, and 90c electrically connected to the circuit element TR.

The circuit element TR may include a channel region CH on an active region AR, a gate structure G on the channel region CH, and source/drain regions S/D on the active region AR and next to the gate structure G.

In an embodiment of the present inventive concept, the channel region CH may include a plurality of channel layers stacked and spaced apart from each other in a vertical direction (Z), perpendicular to an upper surface of the semiconductor substrate, the gate structure G may be disposed to cross the plurality of channel layers and surround each of the plurality of channel layers, and the plurality of channel layers of the channel region CH may be disposed between the source/drain regions S/D. Therefore, the circuit element TR may include a transistor having a multi bridge channel field effect transistor (FET) (MBCFET^{™}) structure, which may be a gate-all-around type field effect transistor. In an embodiment of the present inventive concept, the circuit device TR may include a fin field effect transistor (FinFET) device, a metal oxide semiconductor field effect transistor (MOSFET) device having a vertical channel, or a planar MOSFET device.

The contact plugs 90a may be disposed to penetrate into the source/drain regions S/D to be directly in contact with the source/drain regions S/D, and may function as source/drain contacts.

The semiconductor device 1 may further include a lower insulating structure (110, 120, and 121) on the upper surface of the semiconductor substrate.

The lower insulating structure (110, 120, and 121) may include a first lower insulating layer 110 defining the active region AR, a second lower insulating layer 120 on the first lower insulating layer 110, and a third lower insulating layer 121 on the second lower insulating layer 120 and the circuit element TR. At least one of the first to third lower insulating layers 110, 120, and 121 may include silicon oxide (SiO₂). For example, each of the first to third lower insulating layers 110, 120, and 121 may be formed of silicon oxide (SiO₂).

The lower insulating structure (110, 120, and 121) may further include a lower etch stop layer 124 on the third lower insulating layer 121, and an intermediate insulating layer 127 on the lower etch stop layer 124.

The intermediate insulating layer 127 may be, for example, silicon oxide (SiO₂), tetraethylorthosilicate (TEOS) oxide, carbon doped silicon oxide (SiOCH), or silicon oxycarbide (SiOC), but the present inventive concept is not limited thereto.

The lower etch stop layer 124 may be an insulating material containing at least one of, for example, aluminum nitride (AlN), silicon nitride (SiN), silicon boron nitride (SiBN), or silicon carbonitride (SiCN).

The semiconductor device 1 may further include a first insulating structure (148 and 150) on the lower insulating structure (110, 120, and 121).

The first insulating structure (148 and 150) may include intermetallic barrier layers 148 and intermetallic insulating layers 150, alternately and repeatedly stacked on the lower insulating structure (110, 120, and 121).

The first insulating structure (148 and 150) may have a thickness ranging from about 0.1 µm to about 0.5 µm.

The lower etch stop layer 124 and the intermetallic barrier layers 148 may have the same thickness, but the present inventive concept is not limited thereto, and the intermetallic insulating layer 150 may be formed thicker than the lower etch stop layer 124 and the intermetallic barrier layer 148.

Each of the intermetallic barrier layers 148 may include at least one of, for example, aluminum nitride (AlN), silicon nitride (SiN), silicon boron nitride (SiBN), or silicon carbonitride (SiCN). For example, each of the intermetallic barrier layers 148 may include a first layer and a second layer, at least one of the first layer or the second layer may include aluminum nitride (AlN), and a remaining one thereof may include silicon carbonitride (SiCN).

Each of the intermetallic barrier layers 148 may have a thickness of about 3 nm to about 10 nm.

The intermetallic insulating layers 150 may include a first material having a first dielectric constant, lower than a dielectric constant of silicon oxide (SiO₂). The first material may be a low-κ dielectric. For example, a value of the dielectric constant of the first material may range from about 2.5 to 2.7. The dielectric constant of the silicon oxide (SiO₂) may be from about 3.9 to about 4.2, but depending on how the silicon oxide (SiO₂) is formed, the dielectric constant of the silicon oxide (SiO₂) may be less than 3.9 or greater than 4.2.

The semiconductor device 1 may include an interconnection structure.

The interconnection structure may be disposed in the insulating structure (148 and 150), and may include a plurality of interconnection patterns located on different levels. For example, the interconnection structure may include first, second, third, fourth, and fifth metal interconnection patterns M1, M2, M3, M4, and M5 arranged on different levels. Among the first, second, third, fourth, and fifth metal interconnection patterns M1, M2, M3, M4, and M5, each of the second, third, fourth, and fifth metal interconnection patterns M2, M3, M4, and M5 may include a via portion V and an interconnection portion L on the via portion V and extending from the via portion V. The first metal interconnection pattern M1 disposed on the lowest level may include a first interconnection portion L1 and a first conductive via V1 passing through the first interconnection portion L1. The third metal interconnection pattern M3 disposed on the second metal interconnection pattern M2 may include a third interconnection portion L3 and a third conductive via (a via portion) V3 connecting the third interconnection portion L3 to the second metal interconnection pattern M2. The first interconnection portion L1 is similar to the first interconnection pattern 23 as illustrated in FIGS. 2A and 2B, and thus, is also referred to as a first interconnection pattern 123.

Each of the second, third, fourth, and fifth metal interconnection patterns M2, M3, M4, and M5 may include a conductive material pattern 170 and a conductive barrier layer 171 covering side and bottom surfaces of the conductive material pattern 170. The conductive material pattern 170 may include a copper (Cu) material. The conductive barrier layer 171 may include at least one of, for example, titanium (Ti), tantalum (Ta), titanium nitride (TiN), or tantalum nitride (TaN).

Each of the second, third, fourth, and fifth metal interconnection patterns M2, M3, M4, and M5 passes through one intermetallic barrier layer 148 and one intermetallic insulating layer 150, sequentially stacked. For example, any one of the second, third, fourth, and fifth metal interconnection patterns M2, M3, M4, and M5 may pass through one intermetallic insulating layer 150 and one intermetallic barrier layer 148 contacting a lower surface of the one intermetallic insulating layer 150. In an embodiment of the present inventive concept, a lower surface of any one of the second, third, fourth, and fifth metal interconnection patterns M2, M3, M4, and M5 may be coplanar with a lower surface of the one intermetallic barrier layer 148, but the present inventive concept is not limited thereto.

In this case, the first metal interconnection pattern M1 on the lower insulating structure (110, 120, and 121) may have a structure different from that of the second to fifth metal interconnection patterns M2, M3, M4, and M5.

The first metal interconnection pattern M1 may include a first interconnection portion L1 on the lower etch stop layer 124, and a first conductive via V1 passing through the first interconnection portion L1 up to the lower etch stop layer 124.

The first interconnection portion L1 and the first conductive via V1 may include different materials, and the first conductive via V1 may pass through the first interconnection portion L1, may extend in a downward direction while directly contacting the first interconnection portion L1 on an internal sidewall of a through-hole, and may be in contact with an upper surface of a second contact plug 90b. For example, the first conductive via V1 may function as a third contact plug 90c.

Referring to FIG. 9 and/or FIG. 10, in an embodiment of the present inventive concept, the second contact plug 90b may be referred to as a contact structure, the third contact plug 90c may be referred to as a conductive via, the third lower insulating layer 121 may be referred to as an interlayer insulating layer, the intermediate insulating layer 127 and the intermetallic barrier layer 148 together may be referred to as an intermediate insulating structure, and the first interconnection portion L1 or 123 may be referred to as a first interconnection pattern. The contact structure 90b may be connected to the active region AR and may pass through the interlayer insulating layer 121. The intermediate insulating structure 127/148 may have a first hole and may be disposed on the interlayer insulating layer 121. The first interconnection pattern 123 may have a second hole aligned with the first hole, may be disposed on the intermediate insulating structure 127/148 and may have anisotropic resistance characteristics, and the conductive via 90c may pass through the first hole and the second hole to be connected to the contact structure 90b, and connected to the first interconnection pattern 123 through an internal sidewall of the second hole.

Referring to FIG. 9 and/or FIG. 10, in an embodiment of the present inventive concept, the intermetallic barrier layer 148 may be referred to as a first etch stop layer. The intermediate insulating structure 127/148 may include an intermediate insulating layer 127, and a first etch stop layer 148 disposed between the intermediate insulating layer 127 and the first interconnection pattern 123, in which the first etch stop layer 148 may include a through-hole aligned with the first hole and through which the conductive via 90c passes.

Patterns of the first interconnection portion L1 may extend in parallel in one direction on a plane (X-Y plane), parallel to an upper surface of the intermediate insulating layer 127.

The first metal interconnection patterns M1 may have a line width and an interconnection thickness, lower than the upper metal interconnection patterns M2, M3, M4, and M5, and may have, for example, a width of about 10 nm or less.

The first interconnection portion L1 may include a material having anisotropic resistance characteristics. The material having the anisotropic resistance characteristic may be defined that a first resistivity value of the first interconnection portion L1 in a direction (in-plane), parallel to the X-Y plane is different from a second resistivity value of the first interconnection portion L1 in a direction (out of plane), not parallel to the X-Y plane. For example, the second resistivity value may be tens to hundreds of times greater than the first resistivity value.

The first interconnection portion L1 may be a multi-element material having anisotropic resistance characteristics, and may be a material in which multiple elements in a material form a hierarchical structure and are combined to have different characteristics between layers.

As illustrated in FIGS. 1 to 8, the first interconnection portion L1 may form an identical layered structure in a direction (in-plane) (first direction), parallel to the X-Y plane, which may be a deposition surface of the first interconnection portion L1, and may have a hierarchical structure in the Z-direction, perpendicular to the X-Y plane.

Electron mobility in the identical layered structure may be very high to rapidly decrease resistivity, and electron mobility between layers may be very low to rapidly increase resistivity in a direction (out of plane) (second direction), different from the X-Y plane.

A material having a hierarchical structure may be applied to the first interconnection portion L1, to prevent an increase in resistance in the fine pattern by utilizing a significantly low resistivity in a direction (in-plane), parallel to the X-Y plane. A through-hole may be included in the first interconnection portion L1.

The first conductive via V1 may pass through the through-hole, and may be in direct contact with a side surface of the first interconnection portion L1 on an internal sidewall of the through-hole. The first conductive via V1 may include a material different from that of the first interconnection portion L1, and may include, for example, cobalt (Co), ruthenium (Ru), molybdenum (Mo), copper (Cu), aluminum (Al), or tungsten (W).

The first conductive via V1 and the first interconnection portion L1 may have a pad surface directly contacting the internal sidewall of the through-hole, to contact the first conductive via V1 in a first direction in which resistivity of the first interconnection portion L1 is low, to significantly decrease contact resistance. Therefore, signal RC delay may be reduced.

An etch stop layer 128 may be further included on the first interconnection portion L1.

The etch stop layer 128 may function as a polishing stop layer, when the first conductive via V1 is formed by chemical mechanical polishing (CMP).

The etch stop layer 128 may include a through-hole through which the first conductive via V1 passes, and the through-hole of the upper etch stop layer 128 may be aligned with the through-hole of the first interconnection portion L1. An upper surface of the etch stop layer 128 may be coplanar with an upper surface of the first conductive via V1.

The lowermost one of the intermetallic barrier layers 148 may include a first region located below the first interconnection portion L1, and a different region, for example, a second region disposed below the lowermost one of the intermetallic insulating layers 150, and a portion of the second region may be removed to have a step difference of a predetermined depth. Due to the step difference of the lowermost one of the intermetallic barrier layers 148, the lower surface of the lowermost one of the intermetallic insulating layers 150 may be formed lower than the lower surface of the first interconnection portion L1, resulting in insulation such that residual metal does not exist between the first interconnection portions L1.

The first conductive via V1 may successively pass through the etch stop layer 128, the first interconnection portion L1, the first intermetallic barrier layer 148, the intermediate insulating layer 127, and the lower etch stop layer 124, may form a pad surface with the first interconnection portion L1 on the internal sidewall of the through-hole of the first interconnection portion L1, and may be connected to the second contact plug 90b.

The first interconnection portion L1 may be disposed in the first intermetallic insulating layer 150, and the first conductive via V1 protruding below the first interconnection portion L1 may pass through the intermediate insulating layer 127 to be connected to the second contact plug 90b. In an embodiment of the present inventive concept, the intermediate insulating layer 127 may be omitted.

In this manner, in a semiconductor device 1 including a transistor and a multilayer interconnection structure, a material having anisotropic resistance characteristics with a very low in-plane resistivity starting from a lower interconnection structure to which a fine pattern with an interconnection width of about 10 nm or less is applied, may be applied. To maintain an effect of very low resistivity, a wedge-shaped via structure may be applied such that connection between the first interconnection portion L1 and the first conductive via V1 is performed along a side surface thereof.

FIG. 10 may be a cross-sectional view illustrating a modified example of the interconnection structure illustrated in FIG. 9.

In a modified example, referring to FIG. 10, a semiconductor device 1 may include a second interconnection portion L2 to which a material having anisotropic resistance characteristics is also applied to the second metal interconnection patterns M2 on the first metal interconnection patterns M1.

An intermediate insulating layer 127 may be further disposed on the first metal interconnection patterns M1, and a second interconnection portion L2 on the intermediate insulating layer 127 and a wedge-shaped second conductive via V2 passing therethrough may be included. For example, in addition to the intermediate insulating layer 127 formed on the lower etch stop layer 124 and below first interconnection portion L1 of the first metal interconnection pattern M1, an intermediate insulating layer 127 may be further formed on one intermetallic barrier layer 148 located above the first metal interconnection pattern M1.

A thickness and a material of the intermediate insulating layer 127 may be the same as those described above.

A material, a layer structure, and a width of each layer of the second interconnection portion L2 may be the same as those of a first interconnection portion L1. For example, the second interconnection portion L2 may also include a material having anisotropic resistance characteristics, and a pad surface may be formed on an internal sidewall of a through-hole in the second conductive via V2 and the second interconnection portion L2.

The second conductive via V2 may be a structure for electrically connecting the first interconnection portion L1 and the second interconnection portion L2, and may pass integrally through from an upper surface of the second interconnection portion L2 to a lower surface of the first interconnection portion L1. The first interconnection portion L1 may include a plurality of through-holes such that first conductive vias V1 of the first metal interconnection patterns M1 and second conductive vias V2 of the second metal interconnection patterns M2 pass through while being spaced apart from each other.

A pad surface between the second conductive vias V2 and the interconnection portions L1 and L2 between two layers of the interconnection portions L1 and L2 may not be formed in a vertical direction, but may be disposed on the internal sidewall of the through-hole in a lateral direction.

When multilayer interconnection patterns are implemented with a fine pattern having a width of about 10 nm or less, a material having anisotropic resistance characteristics may be applied to each interconnection pattern to prevent a rapid increase in resistance of each interconnection pattern. **In** this case, the interconnection structure may have a wedge-shaped structure simultaneously passing through the multilayer interconnection pattern to contact the conductive via (V1 and V2) in plane, in which the multilayer interconnection pattern has low resistance due to anisotropic resistance characteristics. For example, the first conductive via V1 having the wedge-shaped structure may provide a low contact resistance with the first interconnection portion L1 at the pad surface disposed in a first through hole passing through the first interconnection portion L1. The second conductive via V2 having the wedge-shaped structure may provide a low contact resistance with the first interconnection portion L1 at the pad surface disposed in a second through hole passing through the first interconnection portion L1, and may provide a low contact resistance with the second interconnection portion L2 at the pad surface disposed in a third through hole passing through the second interconnection portion L2.

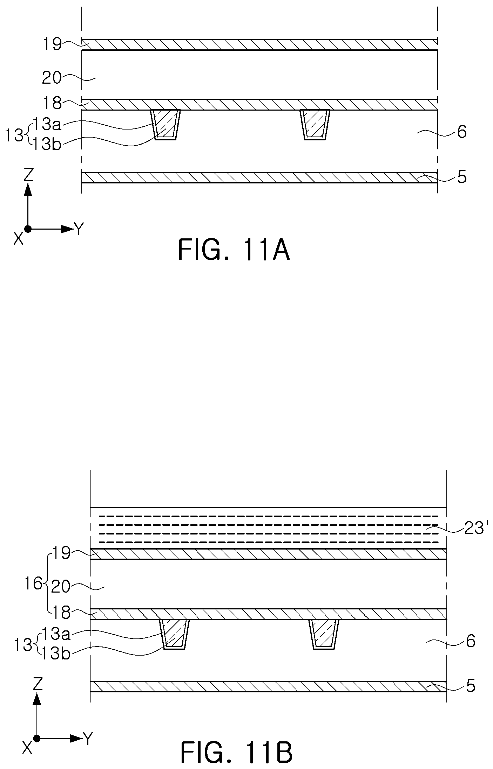

Next, with reference to FIGS. 1 and 11A to 11M, an illustrative example of a method of forming a semiconductor device 1 according to an embodiment of the present inventive concept will be described. FIGS. 11A to 11M may be cross-sectional views schematically illustrating portions of FIG. 1, taken along line I-I'.

Referring to FIGS. 1 and 11A, a lower structure LS may be formed. The formation of the lower structure LS may include forming a first lower insulating layer 6 on a base 5, forming a lower interconnection structure 13 in the first lower insulating layer 6, and forming a first insulating structure 16 covering the first lower insulating layer 6 and the lower interconnection structure 13. The first lower insulating layer 6 may include silicon oxide (SiO₂) or a low-κ dielectric.

The lower interconnection structure 13 may include an interconnection material layer 13b and a barrier material layer 13a covering side and bottom surfaces of the interconnection material layer 13b. The interconnection material layer 13b may include copper (Cu), and the barrier material layer 13a may include at least one of, for example, titanium (Ti), tantalum (Ta), titanium nitride (TiN), or tantalum nitride (TaN). The first insulating structure 16 may include a second etch stop layer 18, an intermediate insulating layer 20 on the second etch stop layer 18, and a first etch stop layer 19 on the intermediate insulating layer 20, in sequence as a layered structure.

The first and second etch stop layers 19 and 18 may be formed of an insulating material including at least one of aluminum nitride (AlN), silicon nitride (SiN), silicon boron nitride (SiBN), or silicon carbonitride (SiCN), but the present inventive concept is not limited thereto. For example, the first and second etch stop layers 19 and 18 may be formed of an insulating material, different from silicon oxide (SiO₂).

The intermediate insulating layer 20 may be formed of silicon oxide (SiO₂) or tetraethylorthosilicate (TEOS) oxide, or may be formed of carbon doped silicon oxide (SiOCH) or silicon oxycarbide (SiOC).

The intermediate insulating layer 20 and the first and second etch stop layers 19 and 18 may form a first insulating structure 16.

Referring to FIGS. 1 and 11B, a first interconnection layer 23' may be formed on the first etch stop layer 19, for example, on the first insulating structure 16.

The first interconnection layer 23' may include a material having anisotropic resistance characteristics. The material having the anisotropic resistance characteristic may be defined that a first resistivity value of the first interconnection layer 23' in a direction (in-plane), parallel to the X-Y plane is different from a second resistivity value of the first interconnection layer 23' in a direction (out of plane), not parallel to the X-Y plane. For example, the second resistivity value may be tens to hundreds of times greater than the first resistivity value.

The first interconnection layer 23' may be a multi-element material having anisotropic resistance characteristics, and may be a material in which multiple elements in a material form a hierarchical structure and are combined to have different characteristics between layers.

On the first etch stop layer 19, the first interconnection layer 23' may be formed by depositing a multi-element material forming the first interconnection layer 23'.

In this case, in the forming of the first interconnection layer 23', to form the hierarchical structure, a multi-element material may be deposited by sputtering to have a predetermined thickness, and then sintered by heat treatment at a high temperature. In this case, the heat treatment temperature may be in a range from about 700°C to about 800°C.

Alternatively, after performing atomic layer deposition (ALD) to form a hierarchical structure, a crystal direction may be controlled by injecting energy by plasma or heat treatment, to induce crystal growth in a desired direction. In this case, the energy injection may be performed alternately with formation of each layer, but may be performed once after all of the first interconnection layers 23' are stacked.

The first interconnection layer 23' may include a conductive material including at least one of an intermetallic compound, an oxide, a carbide, a nitride, or a boride. For example, the first interconnection layer 23' may be a carbide or a nitride, and may be a material having an MAX phase. For example, the first interconnection layer 23' may be an oxide including a delafossite-based material. For example, the first interconnection layer 23' may be intermetallic compounds, and may include a topological semimetal material or the like. For example, the first interconnection layer 23' may be a boride material having a hierarchical structure.

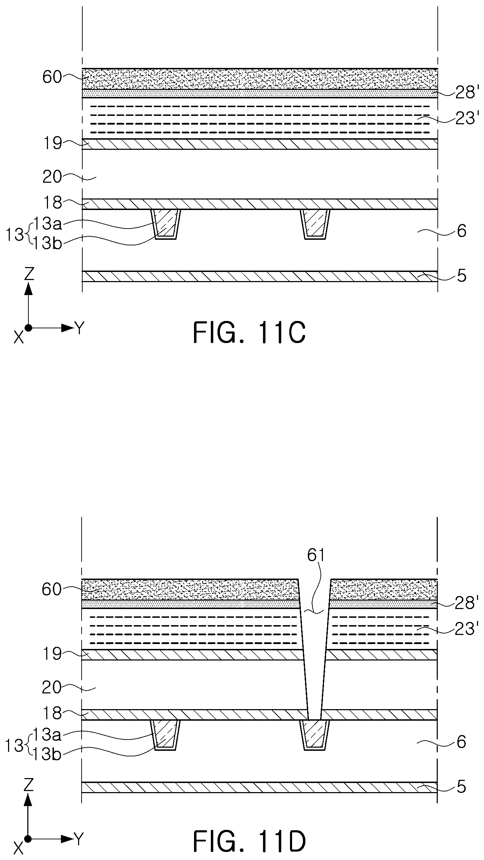

When the first interconnection layer 23' of a predetermined thickness is formed in this manner, a preliminary upper etch stop layer 28' and a mask 60 may be formed on the first interconnection layer 23', as illustrated in FIGS. 1 and 11C.

First, the preliminary upper etch stop layer 28' may be stacked on the first interconnection layer 23', and the preliminary upper etch stop layer 28' may be formed of a material the same as that of the first and second etch stop layers 19 and 18, but the present inventive concept is not limited thereto. The upper etch stop layer 28 may include a material the same as that of the first and second etch stop layers 19 and 18, but the present inventive concept is not limited thereto.

The mask 60 may be a hard mask for forming a fine pattern when forming a lower through-hole.

Referring to FIGS. 1 and 11D, after forming a resist pattern for forming a via hole 61 on the mask 60 and patterning the mask 60 accordingly, the via hole 61 may be formed along the mask 60. A photolithography process may be used to form the resist pattern. A reactive ion etching (RIE) process may be used to pattern the mask 60 and to form the via hole 61.

In the forming of the via hole 61, the via hole 61 may be formed by continuously exposing from the preliminary upper etch stop layer 28' to the second etch stop layer 18 to expose an upper portion of the lower interconnection structure 13. Therefore, after a first through-hole 23o of a first interconnection pattern 23 is also formed simultaneously, the mask 60 may be removed.

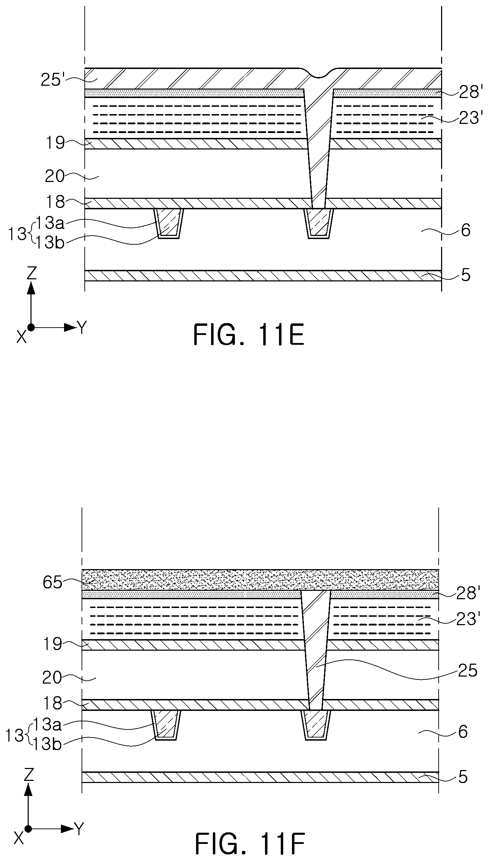

Referring to FIGS. 1 and 11E, a metal layer 25' may be deposited to fill the via hole 61 and cover the preliminary upper etch stop layer 28'. The metal layer 25' may be, for example, ruthenium (Ru), molybdenum (Mo), cobalt (Co), copper (Cu), aluminum (Al), or tungsten (W), but the presentive inventive concept is not limited thereto. The metal layer 25' may be deposited by, for example, a chemical vapor deposition (CVD) process or the like, but the present inventive concept is not limited thereto.

Referring to FIG. 11F, a conductive via 25 may be completed by performing a planarization process to expose the preliminary upper etch stop layer 28'. The planarization process may be a chemical mechanical polishing (CMP) process or an etch back process.

The conductive via 25 may pass through the first through-hole 23o, and may be in direct contact with a side surface of the first interconnection patterns 23 on an internal sidewall of the first through-hole 23o.

The conductive via 25 may include a material different from that of the first interconnection patterns 23, and may include, for example, ruthenium (Ru), molybdenum (Mo), cobalt (Co), copper (Cu), aluminum (Al), or tungsten (W).

Referring to FIG. 2A, since the conductive via 25 and the first interconnection patterns 23 may have a pad surface directly contacting the internal sidewall of the first through-hole 23o, to contact the conductive via 25 in a first direction in which resistivity of the first interconnection patterns 23 is low, to significantly decrease contact resistance. Therefore, signal RC delay may be reduced.

Depending on a shape of the via hole 61, the conductive via 25 may also have a shape of which a width decreases in a downward direction, but the present inventive concept is not limited thereto. Referring to FIG. 2A, the conductive via 25 may include an upper surface 25b, a lower surface 25c, and a side surface 25a connecting the upper surface 25b and the lower surface 25c, and the upper surface 25b may have a level, equal to or higher than that of an upper surface of the first interconnection patterns 23, and the lower surface 25c may have a level, lower than that of a lower surface of the first interconnection patterns 23.

A mask 65 may be formed on the conductive via 25 and the preliminary upper etch stop layer 28'. The mask 65 may be for patterning the first interconnection layer 23', and a material thereof may be the same as that of the mask 60 applied previously.

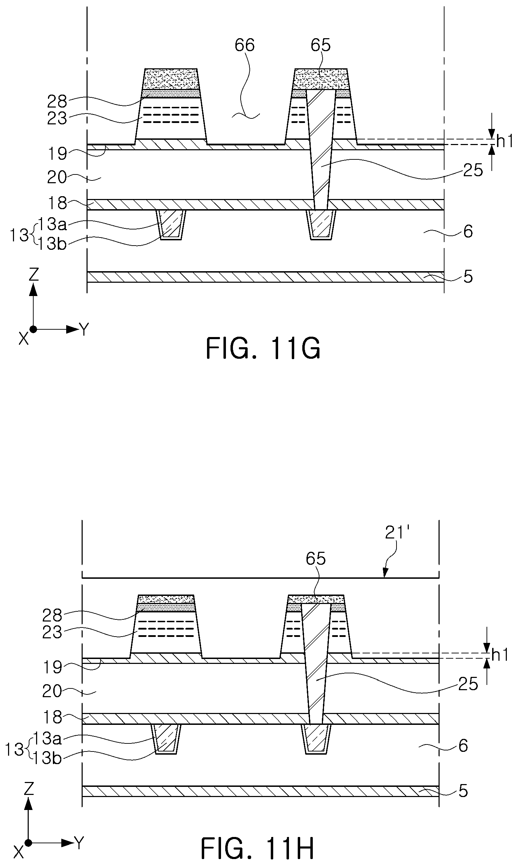

Referring to FIG. 11G, after forming a resist for printing on the mask 65 and patterning the mask 65 accordingly, the first interconnection layer 23' may be patterned and cleaned using the mask 65, to form the first interconnection patterns 23. At the same time, the preliminary upper etch stop layer 28' may also be patterned to form the upper etch stop layer 28.

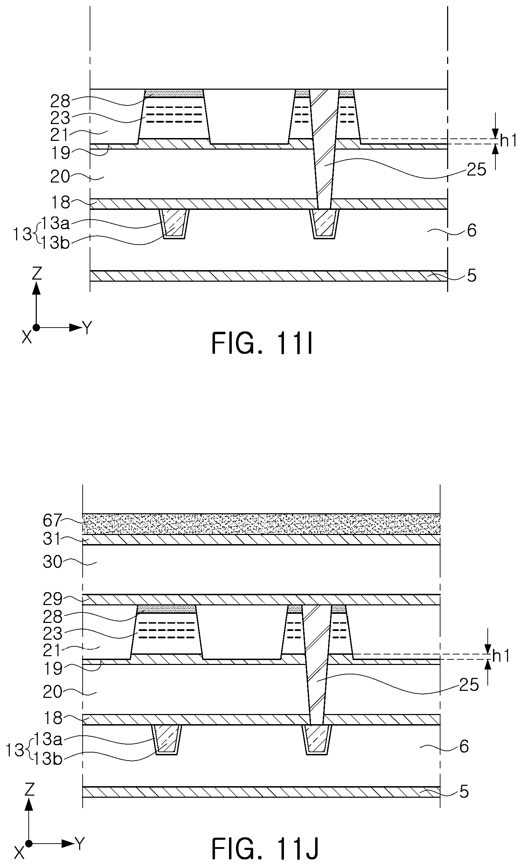

Etching to form a separation space 66 by patterning the first interconnection patterns 23 may be performed in multiple stages. For example, etching may be performed primarily to an upper portion of the first etch stop layer 19, and secondarily, additional etching may be performed to overetch the first etch stop layer 19 to a first depth h1. Due to the additional etching, the first etch stop layer 19 may have a step difference below the first interconnection pattern 23 and the first interconnection insulating layer 21 (see FIG. 11I), such that a material of the first interconnection layer 23' does not remain below the first interconnection insulating layer 21.

During the process of removing a portion of the first interconnection layer 23' to form the first interconnection patterns 23, the etching process may be performed to remove the portion of the first interconnection layer 23' primarily to an upper surface of the first etch stop layer 19, and secondarily, additional etching may be performed to completely remove the first etch stop layer 19 to expose the intermediate insulating layer 20. In this case, referring to FIG. 7, the first etch stop layer 19 may be selectively disposed only below first interconnection patterns 23.

Referring to FIG. 11H, after removing the mask 65 partially or completely, the separation space 66 between the first interconnection patterns 23 may be filled to form an insulating layer 21'. Silicon oxide (SiO₂) may be applied to the insulating layer 21'. The insulating layer 21' may be overstacked, covering the upper etch stop layer 28.

Referring to FIG. 11I, a planarization process may be performed, and the insulating layer 21' may be etched until the upper etch stop layer 28 is exposed. Therefore, planarization may be achieved, such that an upper surface of the upper etch stop layer 28, an upper surface of the first interconnection insulating layer 21, and an upper surface of the conductive via 25 are coplanar.

In this case, as illustrated in FIG. 5, when planarization is performed until an upper surface of the first interconnection pattern 23 is exposed, the upper etch stop layer 28 may be completely removed.

Again, referring to FIG. 11J, a second insulating structure (29, 30, and 31) may be formed on the first interconnection patterns 23. For example, the second insulating structure (29, 30, and 31) may be formed to cover the upper surfaces of the upper etch stop layer 28, the first interconnection insulating layer 21, and the conductive via 25.

In the second insulating structure (29, 30, and 31), like the first insulating structure 16 described above, a second etch stop layer 29, an intermediate insulating layer 30, and a first etch stop layer 31 may be formed in sequence, and materials and thicknesses thereof may be the same as those described previously.

A mask 67 may be formed on the first etch stop layer 31.

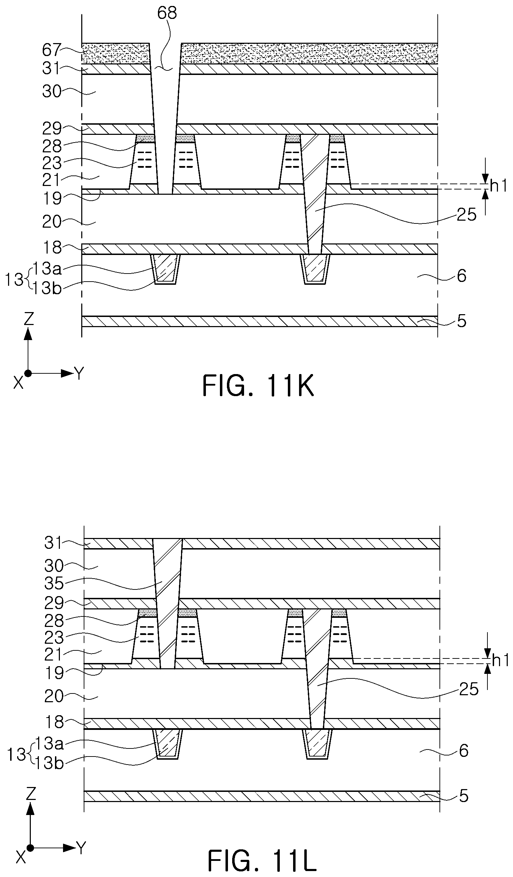

Referring to FIG. 11K, an upper via hole 68 may be formed by forming a resist on the mask 67 and printing and cleaning the same.

The upper via hole 68 may continuously expose from the first etch stop layer 31 of the second insulating structure (29, 30, and 31) in an upper portion to the first etch stop layer 19 in a lower portion, disposed below the first interconnection pattern 23. Therefore, the intermediate insulating layer 20 of the first insulating structure 16 may be exposed.

Referring to FIG. 11L, an upper conductive via 35 may be further formed by filling the upper via hole 68.

In this case, after a conductive layer is formed to fill the upper via hole 68, planarization may be performed to form the upper conductive via 35.

When forming the upper via hole 68, etching may be stopped by the first etch stop layer 19, and in the upper conductive via 35 filling the upper via hole 68, planarization may be stopped by the upper first etch stop layer 31.

By the planarization process, the upper conductive via 35 having an upper surface coplanar with the first etch stop layer 31 of the second insulating structure (29, 30, and 31) may be formed. The upper conductive via 35 may integrally extend from the first etch stop layer 19 to the first etch stop layer 31 of the second insulating structure (29, 30, and 31), and a pad surface with the first interconnection pattern 23 may be disposed on the internal sidewall of a through-hole of the first interconnection pattern 23 to form a wedge-shaped conductive structure. since the upper conductive via 35 and the first interconnection pattern 23 may have a pad surface directly contacting the upper conductive via 35 and the first interconnection pattern 23 in a first direction in which resistivity of the first interconnection pattern 23 is low, to significantly decrease contact resistance. Therefore, signal RC delay may be reduced.

Referring to FIG. 11M, a conductive material layer may be formed on the second insulating structure (29, 30, and 31), and the conductive material layer may be patterned to form an upper interconnection structure 36 electrically connected to the upper conductive via 35.

Next, another example of a method of forming a semiconductor device 1 according to an embodiment of the present inventive concept will be described with reference to FIGS. 12A to 12I. FIGS. 12A to 12I may be cross-sectional views schematically illustrating portions of FIG. 1, taken along line I-I'.

In the method of forming the semiconductor device 1 of FIGS. 12A to 12I, formation of a lower structure LS, formation of a first insulating structure 16, and sequential formation of a first interconnection layer 23', a preliminary upper etch stop layer 28', and a mask 70 on the first insulating structure 16 are the same as in FIGS. 11A to 11C, so description thereof will be omitted.

Referring to FIGS. 1 and 12A, after forming a resist for printing on a mask 70 and patterning the mask 70 accordingly, a lower first interconnection layer 23' may be patterned and cleaned by the mask 70 to form first interconnection patterns 23. At the same time, the preliminary upper etch stop layer 28' may also be patterned to form the upper etch stop layer 28.

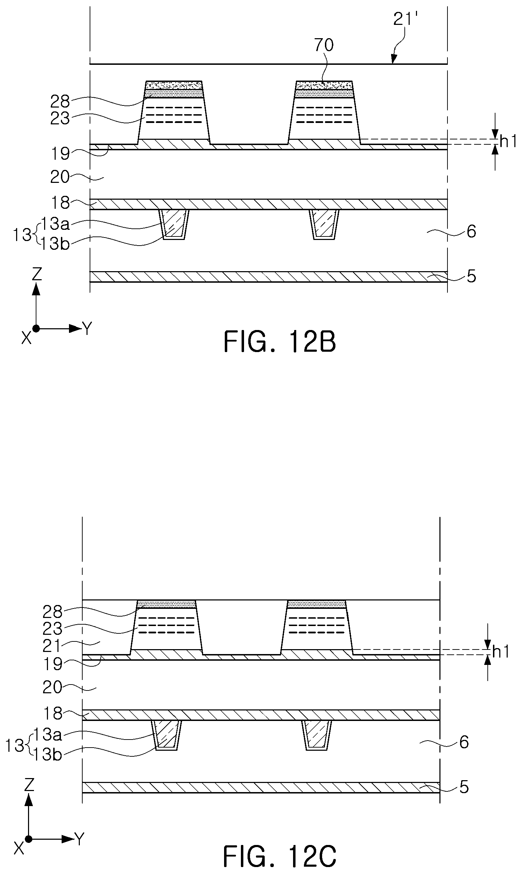

In this case, to pattern the first interconnection patterns 23, etching of the first interconnection layer 23' may be performed in multiple stages. For example, etching may be carried out primarily to have a separation space 71 down to an upper portion of a first etch stop layer 19, and secondarily, additional etching may be performed to overetch to a first depth h1 of the first etch stop layer 19. Due to this additional etching, the first etch stop layer 19 may have a step difference below a first interconnection pattern 23 and a first interconnection insulating layer 21 (see FIG. 12C), such that a material of the first interconnection layer 23' does not remain below the first interconnection insulating layer 21.

Referring to FIGS. 1 and 12B, after partially removing the mask 70 by washing, an insulating layer 21' may be formed by filling the space 71 between the first interconnection patterns 23. Silicon oxide (SiO₂) may be applied to the insulating layer 21'. The insulating layer 21' may be overstacked, covering an upper etch stop layer 28.

Referring to FIG. 12C, a planarization process may be performed to etch the insulating layer 21' until the upper etch stop layer 28 is exposed. Therefore, the planarization may be achieved such that an upper surface of the upper etch stop layer 28 and an upper surface of the first interconnection insulating layer 21 are coplanar.

In this case, as illustrated in FIG. 5, when planarization is performed until an upper surface of the first interconnection pattern 23 is exposed, the upper etch stop layer 28 may be completely removed.

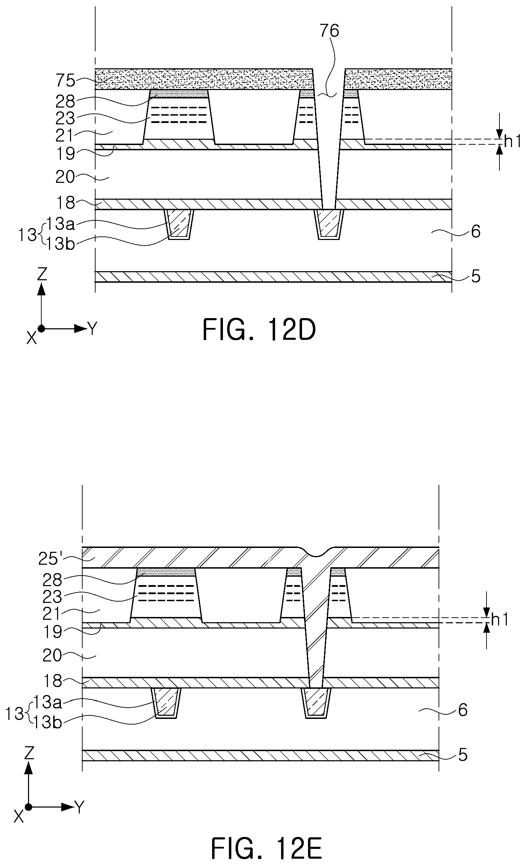

Referring to FIGS. 1 and 12D, a via hole 76 for a conductive via may be formed. For example, a mask 75 may be formed on the upper surfaces of the upper etch stop layer 28 and the upper surfaces of the first interconnection insulating layer 21. After forming a resist pattern for forming the via hole 76 on the mask 75 and patterning the mask 75 accordingly, the via hole 76 may be formed along the mask 75. For example, an etching process may be carried out to form the via hole 76 using the mask 75 as an etch mask.

The forming of the via hole 76 may continuously expose from the upper etch stop layer 28 to the second etch stop layer 18, to form the via hole 76 exposing an upper portion of a lower interconnection structure 13, and the mask 75 may be removed.

Referring to FIGS. 1 and 12E, a metal layer 25' may be deposited to fill the via hole 76 and cover the upper etch stop layer 28 and the first interconnection insulating layer 21.

The metal layer 25' may include a material different from that of the first interconnection patterns 23, and may be formed by depositing a material including at least one of, for example, ruthenium (Ru), molybdenum (Mo), cobalt (Co), copper (Cu), aluminum (Al), or tungsten (W).

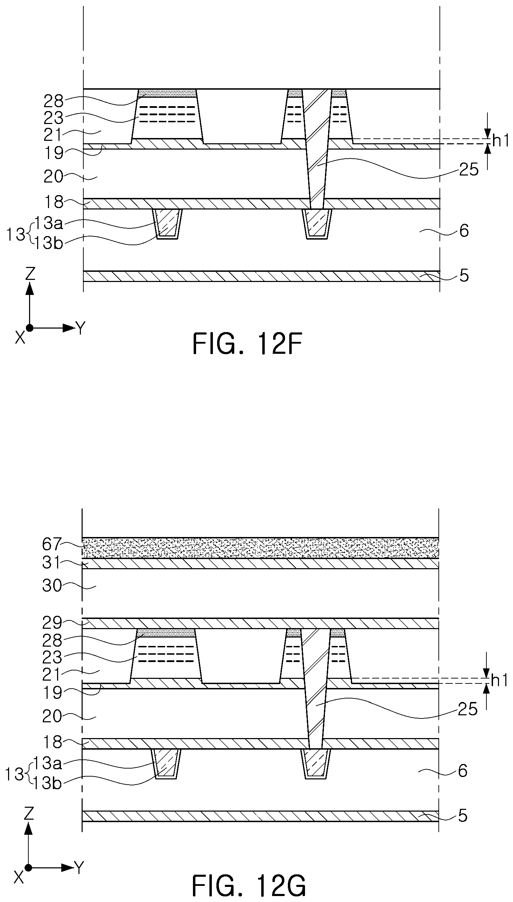

Referring to FIG. 12F, a conductive via 25 may be completed by performing a planarization process, for example, chemical mechanical polishing (CMP), to expose the upper etch stop layer 28.

The conductive via 25 may pass through the via hole 76, and may be in direct contact with a side surface of the first interconnection patterns 23 on an internal sidewall of a first through-hole 23o (see FIG. 2A).

Since the conductive via 25 and the first interconnection patterns 23 may have a pad surface directly contacting the internal sidewall of the first through-hole 23o, to contact the conductive via 25 in a first direction in which resistivity of the first interconnection patterns 23 is low, to significantly decrease contact resistance. Therefore, signal RC delay may be reduced.

Depending on a shape of the via hole, the conductive via 25 may also have a shape of which a width decreases in a downward direction, but the present inventive concept is not limited thereto. The conductive via 25 may include an upper surface, a lower surface, and a side surface connecting the upper surface and the lower surface, and the upper surface may have a level, equal to or higher than that of an upper surface of the first interconnection patterns 23, and the lower surface may have a level, lower than that of a lower surface of the first interconnection patterns 23.

Referring to FIG. 12G, a second insulating structure (29, 30, and 31) may be formed again on the first interconnection patterns 23.

As described above, in the second insulating structure (29, 30, and 31), a second etch stop layer 29, an intermediate insulating layer 30, and a first etch stop layer 31 may be formed in sequence, and materials and thicknesses thereof may be the same as those described previously.

A mask 67 may be formed on the first etch stop layer 31.

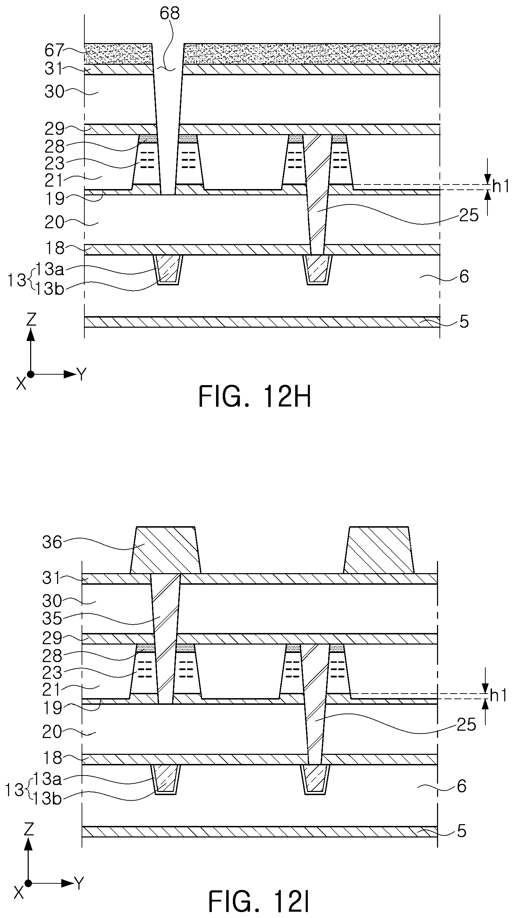

Referring to FIG. 12H, an upper via hole 68 may be formed by forming a resist on the mask 67 and printing and cleaning the same.

The upper via hole 68 may continuously expose from the first etch stop layer 31 of the second insulating structure (29, 30, and 31) in an upper portion to the first etch stop layer 19 in a lower portion, disposed below the first interconnection pattern 23. Therefore, the intermediate insulating layer 20 in the lower portion may be exposed.

Referring to FIG. 12I, an upper conductive via 35 may be further formed by filling the upper via hole 68.

In this case, after a conductive layer is formed to fill the upper via hole 68, planarization may be performed to form the upper conductive via 35.

When forming the upper via hole 68, etching may be stopped by the first etch stop layer 19, and in the upper conductive via 35 filling the upper via hole 68, planarization may be stopped by the upper first etch stop layer 31.

The upper conductive via 35 may integrally extend from the first etch stop layer 19 to the first etch stop layer 31 of the second insulating structure (29, 30, and 31), and a pad surface with the first interconnection pattern 23 may be disposed on the internal sidewall of a through-hole of the first interconnection pattern 23 to form a wedge-shaped conductive structure. since the upper conductive via 35 and the first interconnection pattern 23 may have a pad surface directly contacting the upper conductive via 35 and the first interconnection pattern 23 in a first direction in which resistivity of the first interconnection pattern 23 is low, to significantly decrease contact resistance. Therefore, signal RC delay may be reduced.

By the planarization process, the upper conductive via 35 having an upper surface coplanar with the first etch stop layer 31 in the upper portion of the upper insulating structure (29, 30, and 31) may be formed. A conductive material layer may be formed on the upper insulating structure (29, 30, and 31), and the conductive material layer may be patterned to form an upper interconnection structure 36 electrically connected to the upper conductive via 35.

According to an embodiment of the present inventive concept, a semiconductor device including an interconnection pattern including a material having anisotropic resistance characteristics may be provided. The interconnection pattern may have a very low in-plane resistivity even for a very small line width to reduce RC delay during fine interconnection for scaling of the semiconductor device.

Additionally, a via having a wedge shape may be provided such that the via and an interconnection pattern are in direct contact in a lateral direction in-plane. Therefore, contact resistance between the via and the interconnection pattern may become very small to prevent RC delay during signal transmission.

When an interconnection structure is provided as multiple layers, resistance may be significantly reduced by providing the multiple layers of interconnection patterns having the anisotropic resistance characteristics and forming vias simultaneously passing through the multilayer interconnection patterns. Therefore, performance of the semiconductor device may be enhanced.

Various effects of the present inventive concept may not be limited to the above-described content, and may be more easily understood through description of specific embodiments.

While example embodiments have been illustrated and described above, it will be apparent to those skilled in the art that modifications and variations could be made without departing from the scope of the present inventive concept as defined by the appended claims.

## Claims

1. A semiconductor device (1) comprising:
an insulating structure (16);
a first interconnection pattern (23) having a first through-hole (23o) and disposed on an upper surface of the insulating structure, said first interconnection pattern extending in a first direction on a plane parallel to the upper surface of the first insulating structure; and
a conductive via (25) passing through the first through-hole of the first interconnection pattern and contacting the first interconnection pattern on an internal sidewall of the first through-hole,
wherein the first interconnection pattern includes a material having first resistivity in the first direction, parallel to the upper surface of the insulating structure, and second resistivity in a second direction, different from the first direction and not parallel to the upper surface of the insulating structure, and
the first resistivity is lower than the second resistivity,
**characterized in that**
the first interconnection pattern (23) comprises a conductive material including at least one of an intermetallic compound, an oxide, a carbide, a nitride, or a boride,
wherein the intermetallic compound includes a topological semimetal material, the oxide includes a delafossite-based material, and the carbide or the nitride includes a material having an MAX phase.

2. The semiconductor device of claim 1, wherein the first interconnection pattern (23) and the conductive via (25) comprise different materials.

3. The semiconductor device of claim 1 or 2, wherein the first interconnection pattern (23) has a width of about 10 nm or less.

4. The semiconductor device of any preceding claim, wherein the insulating structure (16) comprises:
an intermediate insulating layer (20); and
a first etch stop layer (19) disposed between the intermediate insulating layer and the first interconnection pattern,
wherein the first etch stop layer includes a second through-hole aligned with the first through-hole (23o) and through which the conductive via (25) passes.

5. The semiconductor device of claim 4, wherein the first etch stop layer (19) comprises a first region located below the first interconnection pattern (23) and a second region excluding the first region,
wherein a level of an upper surface of the first region is higher than a level of an upper surface of the second region.

6. The semiconductor device of claim 4, wherein the first etch stop layer (19) is disposed only below the first interconnection pattern (23).

7. The semiconductor device of claim 4 or 5, wherein the conductive via (25) has an upper surface on a level higher than that of an upper surface of the first interconnection pattern (23), and
wherein the semiconductor device further comprises an upper etch stop layer (28) disposed on the upper surface of the first interconnection pattern and including a third through-hole through which the conductive via (25) passes.

8. The semiconductor device of claim 7, further comprising at least one of an upper interconnection structure (36) disposed on the first interconnection pattern (23) or a lower interconnection structure (13) disposed below the first interconnection pattern,
when the conductive via (25) extends in an upward direction to be connected to the upper interconnection structure, a lower surface of the conductive via is coplanar with a lower surface of the first etch stop layer (19), and
when the conductive via extends in a downward direction to be connected to the lower interconnection structure, an upper surface of the conductive via is coplanar with an upper surface of the upper etch stop layer.

9. The semiconductor device of claim 8, wherein the upper interconnection structure (36) or the lower interconnection structure (13) comprises a second interconnection pattern (12) including a material, identical to that of the first interconnection pattern (23),
wherein the second interconnection pattern includes a fourth through-hole aligned with the first through-hole, and
wherein the conductive via (25) simultaneously passes through the first through-hole and the fourth through-hole, and connects the first interconnection pattern and the second interconnection pattern.

10. The semiconductor device of any preceding claim, wherein the conductive via (25) comprises a material having isotropic resistance characteristics, different from the material of the first interconnection pattern (23).

11. The semiconductor device of claim 1, wherein:
the insulating structure (16) includes an intermediate insulating layer (20), a first etch stop layer (19) on the intermediate insulating layer, and a second etch stop layer (18) below the intermediate insulating layer, and including a lower through-hole exposing simultaneously the intermediate insulating layer, the first etch stop layer, and the second etch stop layer;
the first through-hole (23o) is aligned with the lower through-hole and the first interconnection pattern (23) is disposed on an upper surface of the first etch stop layer;
an upper etch stop layer (28) having a second through-hole aligned with the first through-hole and disposed on the first interconnection pattern; and
the conductive via (25) includes a material, different from that of the first interconnection pattern, and simultaneously fills the first through-hole, the second through-hole, and the lower through-hole, and has an upper surface (25b) coplanar with the upper etch stop layer and a side surface (25a) directly contacting the first interconnection pattern through the internal sidewall of the first through-hole.

## Patentansprüche

1. Halbleitervorrichtung (1) umfassend:
eine Isolierstruktur (16);
ein erstes Verbindungsmuster (23), das ein erstes Durchgangsloch (23o) aufweist und auf der Oberseite der Isolierstruktur angeordnet ist, wobei das erste Verbindungsmuster sich in einer ersten Richtung auf einer Ebene parallel zur Oberseite der ersten Isolierstruktur erstreckt; und
eine leitfähige Durchkontaktierung (25), die durch das erste Durchgangsloch des ersten Verbindungsmusters verläuft und das erste Verbindungsmuster an einer inneren Seitenwand des ersten Durchgangslochs kontaktiert,
wobei das erste Verbindungsmuster ein Material einschließt, das einen ersten spezifischen Widerstand in der ersten Richtung parallel zur Oberseite der Isolierstruktur und einen zweiten spezifischen Widerstand in einer zweiten Richtung aufweist, die sich von der ersten Richtung unterscheidet und nicht parallel zur Oberseite der Isolierstruktur verläuft, und
der erste spezifische Widerstand niedriger als der zweite spezifische Widerstand ist,
**dadurch gekennzeichnet, dass**
das erste Verbindungsmuster (23) ein leitfähiges Material umfasst, das mindestens eines von einer intermetallischen Verbindung, einem Oxid, einem Carbid, einem Nitrid oder einem Borid einschließt,
wobei die intermetallische Verbindung ein topologisches Halbmetallmaterial einschließt, das Oxid ein auf Delafossit basierendes Material einschließt und das Carbid oder das Nitrid ein Material mit einer MAX-Phase einschließt.

2. Halbleitervorrichtung nach Anspruch 1, wobei das erste Verbindungsmuster (23) und die leitende Durchkontaktierung (25) unterschiedliche Materialien umfassen.

3. Halbleitervorrichtung nach Anspruch 1 oder 2, wobei das erste Verbindungsmuster (23) eine Breite von etwa 10 nm oder weniger aufweist.

4. Halbleitervorrichtung nach einem vorstehenden Anspruch, wobei die Isolierstruktur (16) Folgendes umfasst:
eine Zwischenisolierschicht (20); und
eine erste Ätzstoppschicht (19), die zwischen der Zwischenisolierschicht und dem ersten Verbindungsmuster angeordnet ist,
wobei die erste Ätzstoppschicht ein zweites Durchgangsloch einschließt, das mit dem ersten Durchgangsloch (23o) ausgerichtet ist und durch das die leitende Durchkontaktierung (25) verläuft.

5. Halbleitervorrichtung nach Anspruch 4, wobei die erste Ätzstoppschicht (19) einen ersten Bereich unterhalb des ersten Verbindungsmusters (23) und einen zweiten Bereich, der den ersten Bereich ausschließt, umfasst,
wobei ein Niveau einer Oberseite des ersten Bereichs höher ist als ein Niveau der Oberseite des zweiten Bereichs.

6. Halbleitervorrichtung nach Anspruch 4, wobei die erste Ätzstoppschicht (19) nur unterhalb des ersten Verbindungsmusters (23) angeordnet ist.

7. Halbleitervorrichtung nach Anspruch 4 oder 5, wobei die leitfähige Durchkontaktierung (25) eine Oberseite aufweist, die auf einem höheren Niveau liegt als die Oberseite des ersten Verbindungsmusters (23), und
wobei die Halbleitervorrichtung ferner eine obere Ätzstoppschicht (28) umfasst, die auf der Oberseite des ersten Verbindungsmusters angeordnet ist und ein drittes Durchgangsloch einschließt, durch das die leitende Durchkontaktierung (25) verläuft.

8. Halbleitervorrichtung nach Anspruch 7, ferner umfassend mindestens eines von einer oberen Verbindungsstruktur (36), die auf dem ersten Verbindungsmuster (23) angeordnet ist, oder einer unteren Verbindungsstruktur (13), die unterhalb des ersten Verbindungsmusters angeordnet ist,
wenn sich die leitende Durchkontaktierung (25) nach oben erstreckt, um mit der oberen Verbindungsstruktur verbunden zu werden, ist eine Unterseite der leitenden Durchkontaktierung komplanar mit einer Unterseite der ersten Ätzstoppschicht (19), und
wenn sich die leitende Durchkontaktierung nach unten erstreckt, um mit der unteren Verbindungsstruktur verbunden zu werden, ist eine Oberseite der leitenden Durchkontaktierung komplanar mit einer Oberseite der oberen Ätzstoppschicht.

9. Halbleitervorrichtung nach Anspruch 8, wobei die obere Verbindungsstruktur (36) oder die untere Verbindungsstruktur (13) ein zweites Verbindungsmuster (12) umfasst, das ein mit dem ersten Verbindungsmuster (23) identisches Material einschließt.
wobei das zweite Verbindungsmuster ein viertes Durchgangsloch einschließt, das mit dem ersten Durchgangsloch ausgerichtet ist, und
wobei die leitende Durchkontaktierung (25) gleichzeitig durch das erste Durchgangsloch und das vierte Durchgangsloch verläuft und das erste Verbindungsmuster mit dem zweiten Verbindungsmuster verbindet.

10. Halbleitervorrichtung nach einem vorstehenden Anspruch, wobei die leitende Durchkontaktierung (25) ein Material mit isotropen Widerstandseigenschaften umfasst, die sich von dem Material des ersten Verbindungsmusters (23) unterscheiden.

11. Halbleitervorrichtung nach Anspruch 1, wobei:
die Isolierstruktur (16) eine Zwischenisolierschicht (20), eine erste Ätzstoppschicht (19) auf der Zwischenisolierschicht und eine zweite Ätzstoppschicht (18) unterhalb der Zwischenisolierschicht einschließt, und ein unteres Durchgangsloch einschließt, das gleichzeitig die Zwischenisolierschicht, die erste Ätzstoppschicht und die zweite Ätzstoppschicht freilegt;
das erste Durchgangsloch (23o) mit dem unteren Durchgangsloch ausgerichtet ist und das erste Verbindungsmuster (23) auf einer Oberseite der ersten Ätzstoppschicht angeordnet ist;
eine obere Ätzstoppschicht (28) mit einem zweiten Durchgangsloch, das mit dem ersten Durchgangsloch ausgerichtet und auf dem ersten Verbindungsmuster angeordnet ist; und
die leitfähige Durchkontaktierung (25) ein anderes Material als das erste Verbindungsmuster einschließt und gleichzeitig das erste Durchgangsloch, das zweite Durchgangsloch und das untere Durchgangsloch füllt, und eine Oberseite (25b), die komplanar mit der oberen Ätzstoppschicht ist, sowie eine Seitenfläche (25a), die über die innere Seitenwand des ersten Durchgangslochs direkt mit dem ersten Verbindungsmuster in Kontakt steht, aufweist.

## Revendications

1. Dispositif semi-conducteur (1) comprenant :
une structure isolante (16) ;
un premier motif d'interconnexion (23) présentant un premier trou traversant (23o) et disposé sur une surface supérieure de la structure isolante, ledit premier motif d'interconnexion s'étendant dans une première direction sur un plan parallèle à la surface supérieure de la première structure isolante ; et
un via conducteur (25) traversant le premier trou traversant du premier motif d'interconnexion et entrant en contact avec le premier motif d'interconnexion sur une paroi latérale interne du premier trou traversant,
dans lequel le premier motif d'interconnexion inclut un matériau présentant une première résistivité dans une première direction, parallèle à la surface supérieure de la structure isolante, et une seconde résistivité dans une seconde direction, différente de la première direction et non parallèle à la surface supérieure de la structure isolante, et
la première résistivité est inférieure à la seconde résistivité,
**caractérisé en ce que**
le premier motif d'interconnexion (23) comprend un matériau conducteur incluant au moins l'un parmi un composé intermétallique, un oxyde, un carbure, un nitrure ou un borure,
dans lequel le composé intermétallique inclut un matériau semi-métallique topologique, l'oxyde inclut un matériau à base de délafossite, et le carbure ou le nitrure inclut un matériau présentant une phase MAX.

2. Dispositif semi-conducteur selon la revendication 1, dans lequel le premier motif d'interconnexion (23) et le via conducteur (25) comprennent des matériaux différents.

3. Dispositif semi-conducteur selon la revendication 1 ou 2, dans lequel le premier motif d'interconnexion (23) présente une largeur d'environ 10 nm ou moins.

4. Dispositif semi-conducteur selon une quelconque revendication précédente, dans lequel la structure isolante (16) comprend :
une couche isolante intermédiaire (20) ; et
une première couche d'arrêt de gravure (19) disposée entre la couche isolante intermédiaire et le premier motif d'interconnexion,
dans lequel la première couche d'arrêt de gravure inclut un deuxième trou traversant aligné avec le premier trou traversant (23o) et à travers lequel passe le via conducteur (25).

5. Dispositif semi-conducteur selon la revendication 4, dans lequel la première couche d'arrêt de gravure (19) comprend une première région située sous le premier motif d'interconnexion (23) et une seconde région excluant la première région,
dans lequel un niveau d'une surface supérieure de la première région est supérieur à un niveau d'une surface supérieure de la seconde région.

6. Dispositif semi-conducteur selon la revendication 4, dans lequel la première couche d'arrêt de gravure (19) est disposée uniquement sous le premier motif d'interconnexion (23).

7. Dispositif semi-conducteur selon la revendication 4 ou 5, dans lequel le via conducteur (25) présente une surface supérieure à un niveau supérieur à celui d'une surface supérieure du premier motif d'interconnexion (23), et
dans lequel le dispositif semi-conducteur comprend en outre une couche d'arrêt de gravure supérieure (28) disposée sur la surface supérieure du premier motif d'interconnexion et incluant un troisième trou traversant à travers lequel passe le via conducteur (25).

8. Dispositif semi-conducteur selon la revendication 7, comprenant en outre au moins l'une parmi une structure d'interconnexion supérieure (36) disposée sur le premier motif d'interconnexion (23) ou une structure d'interconnexion inférieure (13) disposée sous le premier motif d'interconnexion,
lorsque le via conducteur (25) s'étend dans une direction vers le haut pour être connecté à la structure d'interconnexion supérieure, une surface inférieure du via conducteur est coplanaire avec une surface inférieure de la première couche d'arrêt de gravure (19), et
lorsque le via conducteur s'étend dans une direction vers le bas pour être connecté à la structure d'interconnexion inférieure, une surface supérieure du via conducteur est coplanaire avec une surface supérieure de la couche d'arrêt de gravure supérieure.

9. Dispositif semi-conducteur selon la revendication 8, dans lequel la structure d'interconnexion supérieure (36) ou la structure d'interconnexion inférieure (13) comprend un second motif d'interconnexion (12) incluant un matériau identique à celui du premier motif d'interconnexion (23),
dans lequel le second motif d'interconnexion inclut un quatrième trou traversant aligné avec le premier trou traversant, et
dans lequel le via conducteur (25) traverse simultanément le premier trou traversant et le quatrième trou traversant, et relie le premier motif d'interconnexion et le second motif d'interconnexion.

10. Dispositif semi-conducteur selon une quelconque revendication précédente, dans lequel le via conducteur (25) comprend un matériau présentant des caractéristiques de résistance isotropes, différentes du matériau du premier motif d'interconnexion (23).

11. Dispositif semi-conducteur selon la revendication 1, dans lequel :
la structure isolante (16) inclut une couche isolante intermédiaire (20), une première couche d'arrêt de gravure (19) sur la couche isolante intermédiaire, et une seconde couche d'arrêt de gravure (18) sous la couche isolante intermédiaire, et incluant un trou traversant inférieur exposant simultanément la couche isolante intermédiaire, la première couche d'arrêt de gravure et la seconde couche d'arrêt de gravure ;
le premier trou traversant (23o) est aligné avec le trou traversant inférieur et le premier motif d'interconnexion (23) est disposé sur une surface supérieure de la première couche d'arrêt de gravure ;
une couche d'arrêt de gravure supérieure (28) présentant un deuxième trou traversant aligné avec le premier trou traversant et disposé sur le premier motif d'interconnexion ; et
le via conducteur (25) inclut un matériau différent de celui du premier motif d'interconnexion, et remplit simultanément le premier trou traversant, le deuxième trou traversant et le trou traversant inférieur, et présente une surface supérieure (25b) coplanaire avec la couche d'arrêt de gravure supérieure et une surface latérale (25a) en contact direct avec le premier motif d'interconnexion à travers la paroi latérale interne du premier trou traversant.
